# EUROPEAN PATENT APPLICATION

(11) **EP 1 028 460 A2**
(43) Date of publication of application: **16.08.2000**
(21) Application number: 00300918.0
(22) Date of filing: 07.02.2000
(51) Int. Cl.: H01L 21/768

(54) **Dual damascene misalignment tolerant techniques for vias and sacrificial etch segments**

(30) Priority: 05.02.1999 US 244788
(71) Applicant: Applied Materials, Inc., Santa Clara, California 95050 (US)
(72) Inventor: Parikh, Suketu a., San Jose, California 95135 (US)
(74) Representative: Bayliss, Geoffrey Cyril

(57) **Abstract**

The present invention provides integrated circuit fabrication methods and devices wherein dual damascene structures (552 and 558) are formed in a dielectric stack including three dielectric layers (516, 518 and 530). Via patterns (522 and 524) for these structures have a rectangular shape and are wider than the corresponding overlaying trench patterns (534 and 536). Another embodiment of the present invention provides dual damascene structures (860 and 862) employing a sacrificial etch segment (828) in an etch stop layer (818) of a dielectric stack (810, 816 and 842). The sacrificial etch segment is positioned between adjacent dual damascene interconnect lines (864 and 866) which are formed on the etch stop layer (818). In additional embodiments, manufacturing systems (1210) are provided for fabricating IC structures. These systems include a controller (1200) which is adapted for interacting with a plurality of fabrication stations (1220, 1222, 1224, 1226, 1228 and 1230).

## Description

The present invention relates to semiconductor device interconnect lines and via plugs which are fabricated using damascene techniques.

A semiconductor device such as an IC (integrated circuit) generally has electronic circuit elements such as transistors, diodes and resistors fabricated integrally on a single body of semiconductor material. The various circuit elements are connected through conductive connectors to form a complete circuit which can contain millions of individual circuit elements. Advances in semiconductor materials and processing techniques have resulted in reducing the overall size of the IC circuit elements while increasing their number on a single body. Additional miniaturization is highly desirable for improved IC performance and cost reduction. Interconnects provide the electrical connections between the various electronic elements of an IC and they form the connections between these elements and the device's external contact elements, such as pins, for connecting the IC to other circuits. Typically, interconnect lines form horizontal connections between electronic circuit elements while conductive via plugs form vertical connections between the electronic circuit elements, resulting in layered connections.

A variety of techniques are employed to create interconnect lines and via plugs. One such technique involves a process generally referred to as dual damascene, which includes forming a trench and an underlying via hole. The trench and the via hole are simultaneously filled with a conductor material, for example a metal, thus simultaneously forming an interconnect line and an underlying via plug. Examples of conventional dual damascene fabrication techniques are disclosed in Kaanta et al., "Dual Damascene: A ULSI Wiring Technology", Jun. 11-12, 1991, VMIC Conference. IEEE, pages 144-152 and in U.S. Pat. No. 5,635,423 to Huang et al., 1997.

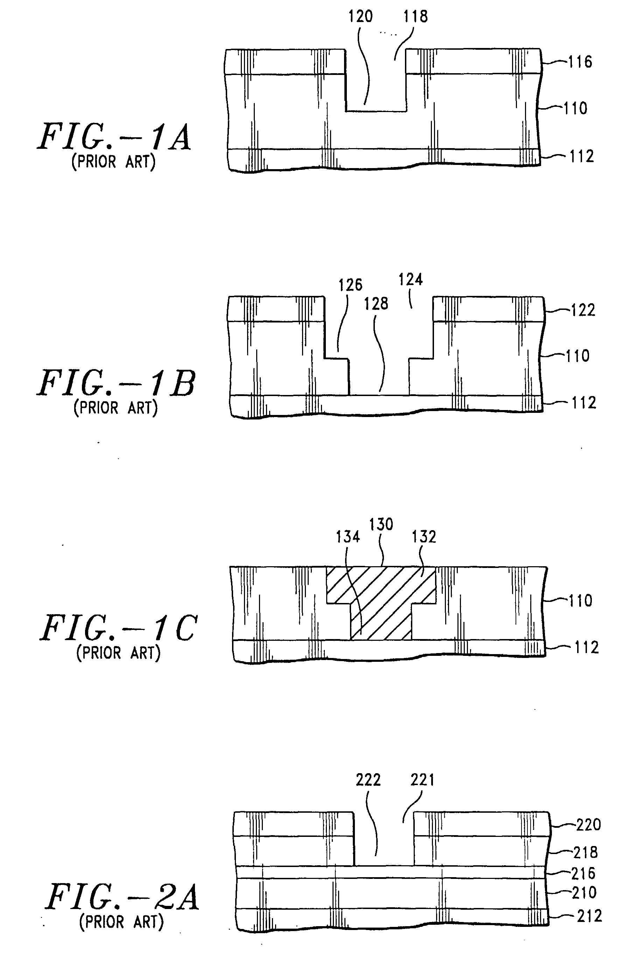

An example of a prior art dual damascene technique is illustrated in FIGS. 1A - 1C, showing various IC structures. As depicted in FIG. 1A, a dielectric layer 110 is deposited on a semiconductor substrate 112. An etch mask 116, having a via pattern 118, is positioned on dielectric layer 110. A timed anisotropic etch is utilized to etch a hole 120 in layer 110 conforming to the via pattern. Mask 116 is subsequently replaced by mask 122 (FIG. 1B) having a trench pattern 124. A timed anisotropic etch is used to form trench 126 and to simultaneously deepen hole 120 to form via hole 128. This via hole can be etched to expose semiconductor substrate 112. Alternatively, the via hole can be over-etched partly into the substrate. As illustrated in FIG. 1C, the via hole and trench are then filled simultaneously with a suitable metal 130. Metal 130 thus forms a metallized interconnect line 132 and a via plug 134 which is in contact with semiconductor substrate 112. Additionally, a liner or barrier layer may be deposited inside the via hole and the trench prior to deposition of the interconnect metal and the via plug. The surface of layer 110 is planarized to remove excess metal 130 and to define interconnect line 132. Alternately, metal etch-back can be utilized to define the line.

Another example of prior art dual damascene is shown in IC structures illustrated in FIGS. 2A - 2C. As depicted in FIG. 2A, a first dielectric layer 210 is deposited on a semiconductor substrate 212. An etch stop layer 216, is deposited on first dielectric layer 210. A second dielectric layer 218 is deposited on etch stop 216, and an etch mask 220 is positioned on dielectric layer 218. Etch mask 220 is patterned (221) for etching a via hole. Second dielectric layer 218 is etched using a first anisotropic etch procedure, to form a hole 222 (FIG. 2A) conforming to the via pattern. This etching procedure is stopped at etch stop layer 216. Etch mask 220 is removed and another etch mask 224 (see, FIG. 2B) is positioned on second dielectric layer 218 such that it is patterned (226) for forming a trench. A second anisotropic etch procedure is used to etch trench 228 in layer 218. Simultaneously, hole 222 is extended to substrate 212, by etching through etch stop layer 216 and through first dielectric layer 210. In this dual damascene technique the first etch procedure has a greater selectivity to etch stop layer 216 than the second etch procedure. As shown in FIG. 2B, the second etch procedure results in forming trench 228 and via hole 230 which extends to semiconductor substrate 212. Mask 224 is removed, after which trench 228 and via hole 230 are simultaneously filled with a suitable conductive metal 232 (see, FIG. 2C) forming metallized line 234 and via plug 236 which contacts substrate 212. Excess metal 232 is removed from the surface of layer 218 to define line 234.

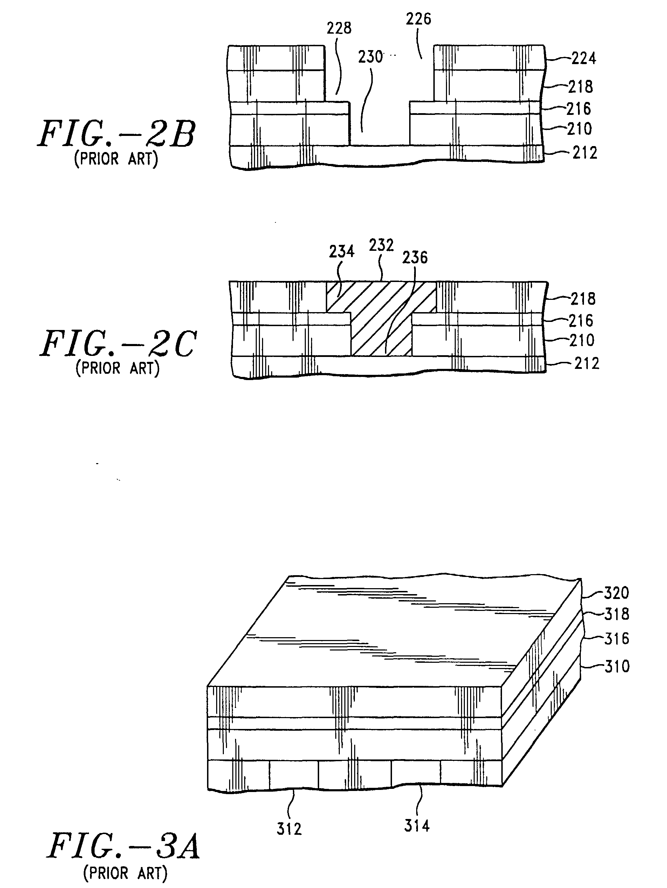

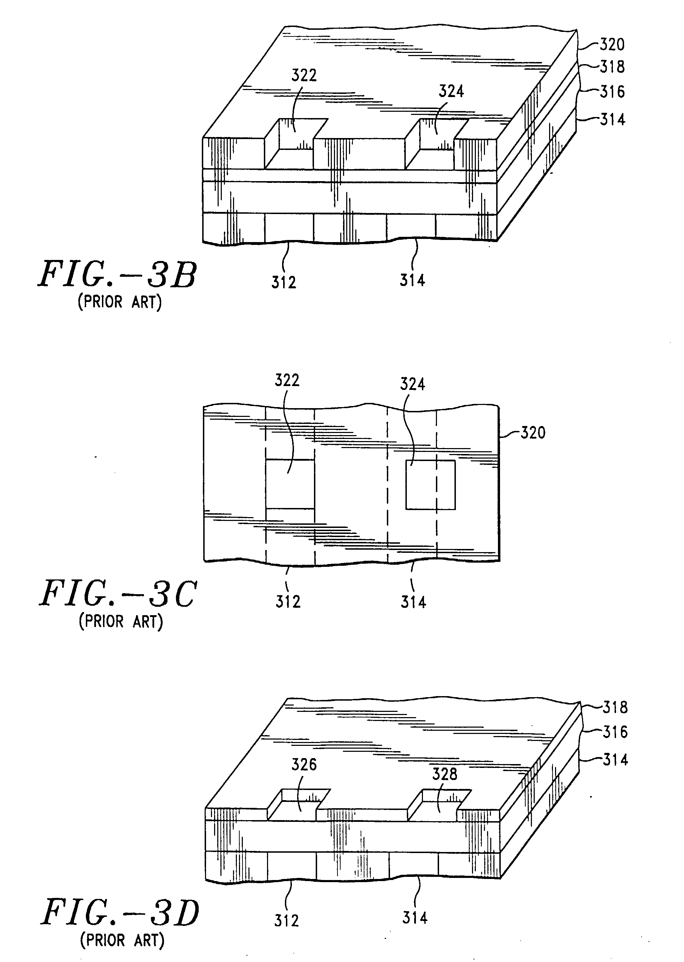

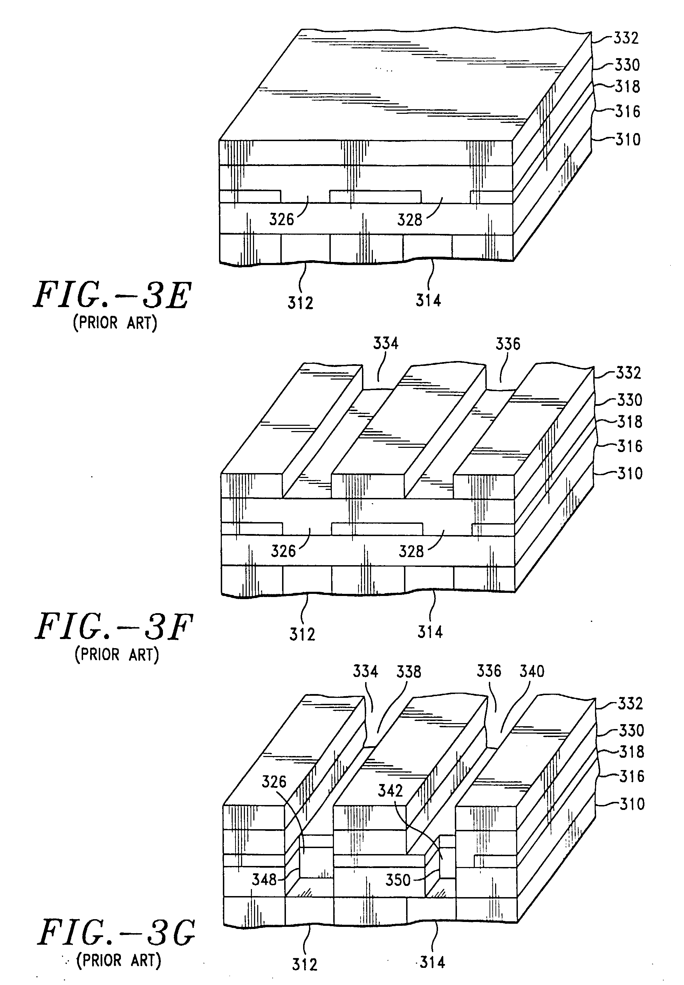

FIGS. 3A - 3I illustrate still another example of a prior art dual damascene technique. As shown in FIG. 3A, a first dielectric layer 316 is deposited on a substrate 310 which includes interconnect lines 312 and 314. A second dielectric layer 318, providing an etch stop, is deposited on layer 316. A first mask layer 320 is deposited on the etch stop layer. Optionally, a cap layer (not shown) may be interposed between the substrate and the first dielectric layer. Via patterns 322 and 324, see FIG. 3B, are formed in mask layer 320. As depicted in FIGS. 3B and 3C, via pattern 322 is aligned with line 312 while via pattern 324 is misaligned with line 314. Misalignments, such as via pattern 324, can occur during the fabrication of IC structures. Via patterns for dual damascene via holes typically have a square cross sectional configuration such that the width and length of the via pattern are similar to, or smaller than, the width of the corresponding trench. As used herein, the width of a via pattern is the dimension which is measured perpendicular to the length dimension of the corresponding damascene trench pattern for the interconnect line. It is desirable to form via plugs having cross sectional dimensions which do not exceed the width of the corresponding interconnect line in order to maximize the number of via plugs which can be fabricated on, or adjacent to, an interconnect line. While FIGS. 3A - 3I illustrate prior art structures employing square via patterns, it will be understood that these prior art techniques are also applicable to via patterns having rounded corners.

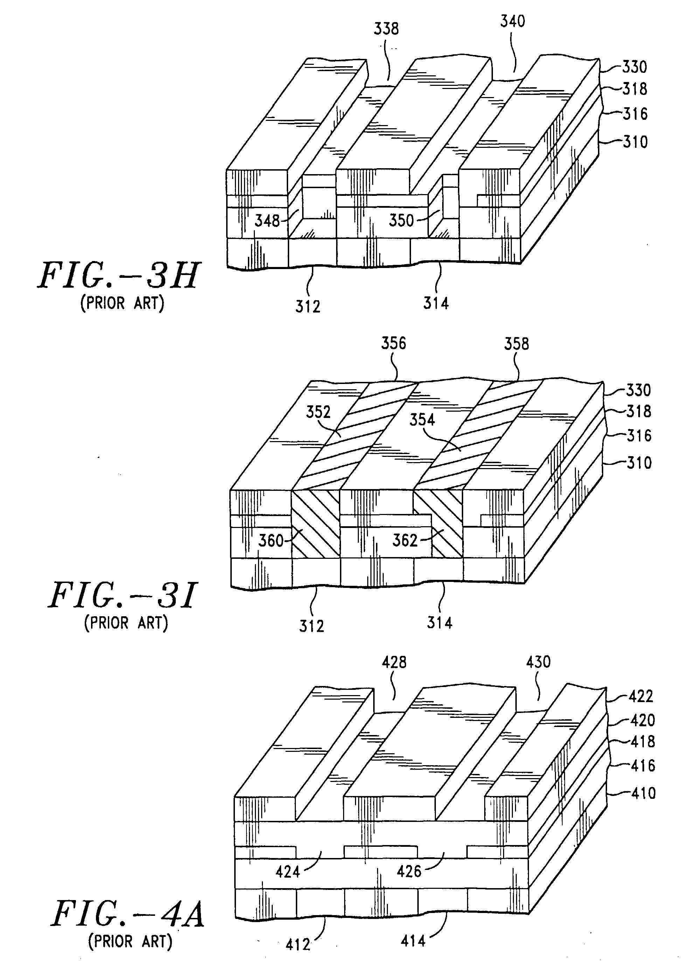

Via patterns 322 and 324 are transferred, by means of anisotropic etching, to etch stop dielectric layer 318 thereby forming via patterns 326 and 328 respectively, see FIG. 3D. First mask layer 320 is then removed. A third dielectric layer 330 (FIG. 3E) is deposited on etch stop layer 318 and inside via patterns 326 and 328 of the etch stop layer. Subsequently, a second mask layer 332 is deposited on third dielectric layer 330. FIG. 3F shows trench patterns 334 and 336 which are formed in second mask layer 332 such that these patterns are aligned with substrate interconnect lines 312 and 314 respectively. Trench patterns 334 and 336 are anisotropically etched through third dielectric layer 330, forming trenches 338 and 340 respectively, see FIG. 3G. The anisotropic etch also removes third dielectric layer 330 material from the portions of via patterns 326 and 328 underlying trenches 338 and 340 respectively. This results in completely opening via pattern 326 (FIG. 3G) which is in good alignment with trench 334. Via pattern 328 is opened only partly due to the misalignment, forming a reduced via pattern 342 which is not opened across the entire width of trench 340. Additional anisotropic etching is utilized to etch via patterns 326 and 342 through first dielectric layer 316 to interconnect lines 312 and 314 of substrate 310, forming via holes 348 and 350. Subsequently, mask layer 332 is removed, as depicted in FIG. 3H. Alternatively, trenches 338 and 340 (FIG. 3H) can be anisotropically etched (not shown) through etch stop layer 318. This etching step can also be utilized to simultaneously anisotropically etch the via holes through a cap layer (not shown) in structures where a cap layer is interposed between the substrate and the first dielectric layer.

The structure depicted in FIG. 3H includes trenches 338 and 340 extending through third dielectric layer 330, and via holes 348 and 350 extending through first and second dielectric layers 316 and 318 respectively. The trenches and via holes are simultaneously filled with a conductive metal forming dual damascene structures 352 and 354 (FIG. 3J) which include interconnect lines 356 and 358, and via plugs 360 and 362 respectively. The prior art technique illustrated in FIGS. 3A - 3I, results in reducing the width of a via hole compared with the width of the corresponding trench and consequently the width of a via plug when the via pattern is misaligned with the underlying interconnect line.

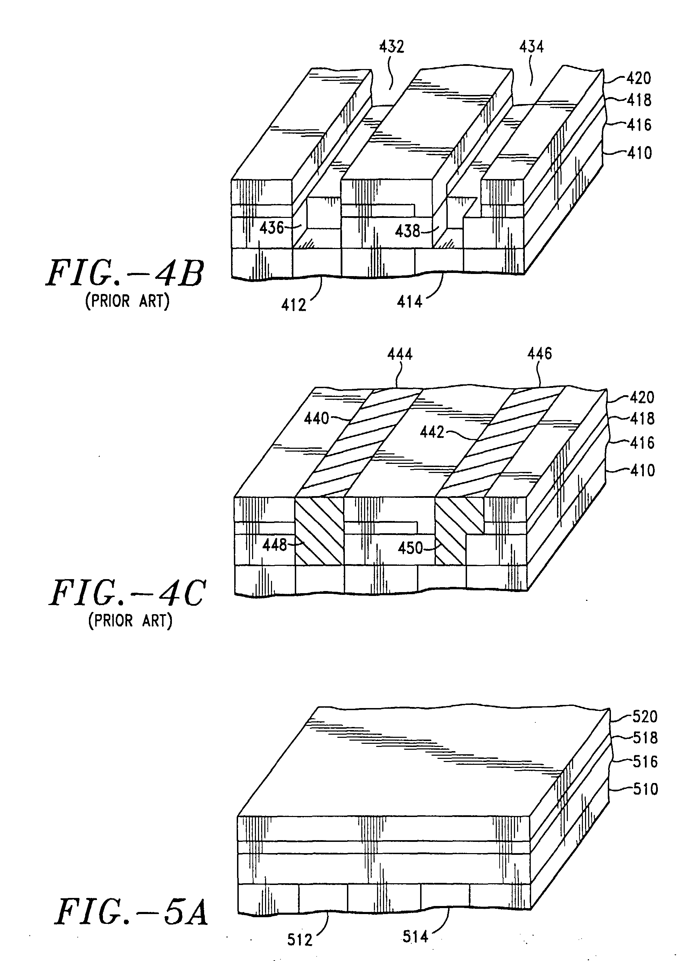

The prior art technique which is shown in FIGS. 3A - 3I illustrates a fabrication sequence wherein the via pattern is misaligned with the underlying interconnect line. These prior art techniques are also utilized in the structures shown in FIGS. 4A - 4C to illustrate the effects of misalignment between a trench pattern and the underlying interconnect lines. FIG. 4A shows a structure which is formed using similar materials and techniques as the structure depicted in FIG. 3F. The structure shown in FIG. 4A includes substrate 410 having interconnect lines 412 and 414, first, second (etch stop) and third dielectric layers 416, 418 and 420, and mask layer 422. Via patterns 424 and 426 are aligned with substrate lines 412 and 414 respectively. Mask layer 422 (FIG. 4A) includes trench pattern 428 which is aligned with line 412 while trench pattern 430 which is misaligned with line 414. FIG. 4B shows the fabrication of trenches 432 and 434 and via holes 436 and 438 using techniques similar to those employed to fabricate the trenches and via holes depicted in FIG. 3H. The trenches and via holes shown in FIG. 4B are simultaneously filled with a conductive metal forming dual damascene structures 440 and 442, see FIG. 4C. These structures include interconnect lines 444 and 446, and via plugs 448 and 450. As illustrated in FIGS. 4B and 4C, the prior art technique utilized in the fabrication of these structures results in a reduced width of the via hole and thus a reduced width of the via plug when the trench pattern is misaligned with the underlying interconnect line.

Conventional dual damascene techniques, such as those exemplified above, have shortcomings for meeting the present and future requirements for reduced design rule and reduced via plug height. For example, the techniques described in connection with FIGS. 1A - 1C utilize a timed etch. As is well known to those of ordinary skill in the art, it is very difficult to precisely control the etching depth when using a timed etch method. Lack of precise etching control can cause quality problems. The etch stop techniques described in connection with FIGS. 2A - 4C provide more etching control than a timed etch. However, the latter prior art technique requires the use of an etch stop layer between adjacent dual damascene structures. As is well known to those of ordinary skill in the art, the presence of an etch stop layer between adjacent dual damascene structures typically results in an increased capacitance between these structures. Also, prior art techniques such as those illustrated in FIGS. 3A - 4C can result in reducing the width of the via hole due to misalignment of the etch patterns. Reduction of the width of the via hole can lead to incomplete metal fill and to increased resistance of the via plug.

Accordingly, a need exists for cost effective, improved techniques for damascene fabrication, wherein a power line and a signal line are simultaneously formed.

The present invention provides novel methods and structures for damascene containing integrated circuit devices which overcome the prior art problems described above.

In one embodiment of the present invention, a first dielectric layer is deposited on a substrate, such as a semiconductor substrate. This is followed by the deposition of a second dielectric layer and a mask layer. A via pattern having a rectangular shape is formed in the mask layer. The first via pattern is anisotropically etched through the second dielectric layer, after which the first mask layer is removed. A third dielectric layer is deposited on the second dielectric layer and inside the via pattern which has been formed in this layer. Next, a second mask layer having a trench pattern overlaying the via pattern is formed on the third dielectric layer. The first via pattern is wider than the trench pattern, to provide misalignment tolerance between the via pattern and the trench pattern. The trench pattern is anisotropically etched through the third dielectric layer, forming a trench, and utilizing the second dielectric layer as the etch stop. The trench etching process also removes the third dielectric layer material from the portion of the first via pattern in the second dielectric layer which is positioned within the trench pattern, thereby forming a second via pattern. The second via pattern can only be formed within the trench pattern, regardless of the width of the original (first) via pattern in the first mask layer. The second via pattern is then anisotropically etched through the first dielectric layer, thereby forming a via hole. The via hole and trench are simultaneously filled with a conductive material, whereby a dual damascene structure is formed. This inventive technique compensates partly or completely for any misalignment between the via pattern and the trench pattern without widening the trench at the position of the via hole, thus overcoming prior art dual damascene fabrication problems associated with misalignment between a via pattern and the corresponding trench pattern. Advantageously, the present embodiment requires only two mask layers for the fabrication of misalignment tolerant dual damascene structures.

In another embodiment of the present invention, a dielectric stack is fabricated which includes an etch stop layer. A portion of the etch stop layer is removed, thereby forming a gap in the etch stop layer. This gap provides a sacrificial etch segment. Two adjacent trenches are formed on the etch stop layer such that the sacrificial etch segment is positioned between the trenches. A via hole is fabricated underneath each trench, wherein the via hole communicates with the corresponding trench. The via holes and trenches are simultaneously filled with a conductive material thus fabricating adjacent dual damascene structures. The sacrificial etch segment between adjacent dual damascene structures forms a gap in the etch stop layer resulting in lower capacitance between the adjacent dual damascene structures as compared with conventional techniques which utilize a continuous etch stop layer between these structures. An example of this novel technique is illustrated utilizing a dielectric stack having consecutive layers comprising a first dielectric layer deposited on a substrate, a second dielectric layer providing an etch stop, and a third dielectric layer. Misalignment can occur between the trench etch patterns and the etch pattern for the sacrificial etch segment. The present technique provides complete or partial compensation for such misalignments by positioning adjacent dual damascene trench masks such that the distance between these masks equals or exceeds the width of the sacrificial etch segment by a measure which equals or exceeds the extent of the misalignment.

In an additional embodiment of the present invention, the above summarized embodiments are combined. The combined novel technique provides novel dual damascene structures which are fabricated using rectangular via patterns where the width of the via pattern exceeds the width of the connecting overlaying trench, and wherein sacrificial etch segments are provided between adjacent trenches. The advantages which are realized from this combined technique include dual damascene structures which are misalignment tolerant with respect to misalignments between etch mask patterns as well as a reduced capacitance between adjacent dual damascene structures.

In another embodiment of the present invention, a first dielectric layer is deposited on a substrate, such as a semiconductor substrate. Second and third dielectric layers are subsequently deposited, followed by the deposition of a hard mask layer. A first photoresist layer having a first via pattern is deposited on the hard mask layer. This via pattern, having a rectangular shape, is wider than the corresponding trench pattern to provide misalignment tolerance between the via pattern and the trench pattern. The first via pattern is transferred to the hard mask layer through anisotropic etching, after which the first resist is stripped. A second resist is deposited on the hard mask layer and inside the via pattern. A trench pattern overlaying the via pattern is developed in the second resist. Formation of this trench pattern removes resist from the portion of the via pattern which is positioned within the trench pattern, thereby forming a second via pattern. The second via pattern can only be formed within the trench pattern, thus providing misalignment tolerance without widening the trench. The second via pattern is anisotropically etched through the third dielectric layer. Next, the trench pattern is anisotropically etched through the hard mask layer while the second via pattern is simultaneously anisotropically etched through the second dielectric layer. Subsequently, the trench pattern is anisotropically etched through the third dielectric layer thereby forming a trench while the second via pattern is simultaneously anisotropically etched through the first dielectric layer resulting in a via hole. The trench and via hole are simultaneously filled with a conductive material to fabricate a dual damascene structure which compensates partly or completely for any misalignment between the via pattern and the trench pattern without widening the interconnect line at the position of the via plug.

In additional embodiments of the present invention, manufacturing systems are provided for forming structures, such as the IC structures of the present invention. These systems include a controller, such as a computer, which is adapted for interacting with a plurality of fabrication stations. Each of these fabrication stations performs a processing step which is utilized to fabricate the IC structures. Operative links provide connections between the controller and the manufacturing stations. A data structure, such as a computer program, causes the controller to control the processing steps which are performed at the fabrication stations. The data structure can be provided on a removable electronic storage medium.

The following is a description of some specific embodiments of the invention, reference being made to the accompanying drawings, in which:

FIGS. 1A - 1C are schematic cross-sectional side views illustrating prior art IC structures at sequential stages.

FIGS. 2A - 2C are schematic cross-sectional side views illustrating prior art IC structures at sequential stages.

FIGS. 3A, 3B and 3D - 3I are schematic cross-sectional side views illustrating prior art IC structures at sequential stages.

FIG. 3C shows a schematic plan view of the IC structure illustrated in FIG. 3B

FIGS. 4A - 4C are schematic cross-sectional side views illustrating prior art IC structures at sequential stages.

FIGS. 5A, 5B and 5D - 5I are schematic cross-sectional side views illustrating an embodiment of IC structures of the present invention at sequential stages.

FIG. 5C shows a schematic plan view of the IC structure illustrated in FIG. 5B.

FIGS. 6A and 6B are schematic cross-sectional side views showing another embodiment of IC structures illustrated in FIGS. 5A - 5I at sequential stages.

FIGS. 7A - 7C are schematic cross-sectional side views showing another embodiment of IC structures illustrated in FIGS. 5A - 5I at sequential stages.

FIGS. 8A and 8C - 8G are schematic cross-sectional side views illustrating another embodiment of IC structures of the present invention at sequential stages.

FIG. 8B shows a schematic plan view of the IC structure illustrated in FIG. 8A.

FIG. 8H shows a schematic plan view of the IC structure illustrated in FIG. 8G.

FIGS. 9A and 9C - 9H are schematic cross-sectional side views illustrating another embodiment of IC structures of the present invention at sequential stages.

FIG. 9B shows a schematic plan view of the IC structure illustrated in FIG. 9A.

FIGS. 10A - 10D and 10F - 10K are schematic cross-sectional side views illustrating another embodiment of IC structures of the present invention at sequential stages.

FIG. 10E shows a schematic plan view of the IC structure illustrated in FIG. 10D.

FIG. 11 is a block diagram illustrating a manufacturing system for fabricating the IC structures of FIGS. 5A - 7C.

FIG. 12 is a block diagram illustrating a manufacturing system for fabricating the IC structures exemplified in FIGS. 8A - 8H.

FIG. 13 is a block diagram illustrating a manufacturing system for fabricating the IC structures of FIGS. 10A - 10K.

While describing the invention and its embodiments, certain terminology will be utilized for the sake of clarity. It is intended that such terminology include not only the recited embodiments but all equivalents which perform substantially the same function, in substantially the same manner to achieve the same result.

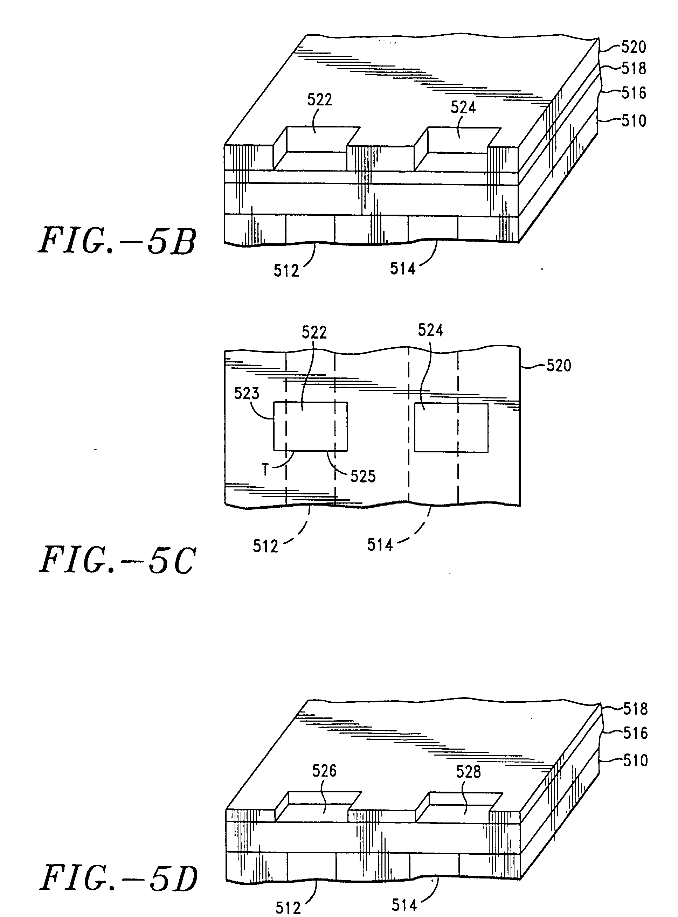

In one embodiment of the invention, a novel dual damascene process is employed wherein a rectangular via pattern is utilized in order to form misalignment tolerant dual damascene structures. The expression "dual damascene structure" as defined herein, includes an interconnect line in a trench and an underlying via plug which are formed simultaneously. This process is illustrated in fabricated structures, such as the IC structures shown in FIGS. 5A - 5I. The expression "integrated circuit structure" as defined herein, includes completely formed integrated circuits and partially formed integrated circuits. FIG. 5A shows a structure generally similar to the prior art structure shown in FIG. 3A. A first dielectric layer 516 is deposited on a semiconductor substrate 510 including interconnect lines 512 and 514. The expression "semiconductor substrate" as defined herein, includes structures and devices comprising typical integrated circuit elements, components, interconnects and semiconductor materials. A second dielectric layer 518, having a thickness typically ranging from about 50 Å to about 4000 Å, is deposited on first dielectric layer 516. The first and second dielectric layers 516 and 518 have dissimilar etching characteristics. The expression "dissimilar etching characteristics" of two materials as defined herein, includes etching properties of these materials such that one of the materials has a higher etch rate than the other material in a specific etch chemistry. A mask layer 520 is deposited on second dielectric layer 518.

As depicted in FIGS. 5B and 5C, mask layer 520 is developed to form novel rectangular via patterns 522 and 524. These via patterns are shaped such that the length of the via pattern is similar to the width of the overlaying trench pattern which will be formed in a subsequent mask layer, such as width P of trench pattern 534 shown in FIG. 5F. The length of the via pattern as used herein refers to the via pattern dimension which is substantially parallel to the length of the trench pattern. For example, via pattern side 523 (FIG. 5C) forms the length dimension of via pattern 522. The width of the novel via patterns exceeds the width of the overlaying trench pattern, preferably by at least 0.02µ, wherein the via pattern width as used herein refers to the via pattern dimension which is substantially perpendicular to the trench pattern. For example, via pattern side 525 (FIG. 5C) forms width dimension T of via pattern 522. FIGS. 5B and 5C show via pattern aligned with substrate interconnect line 512, while via pattern 524 is misaligned with substrate line 514.

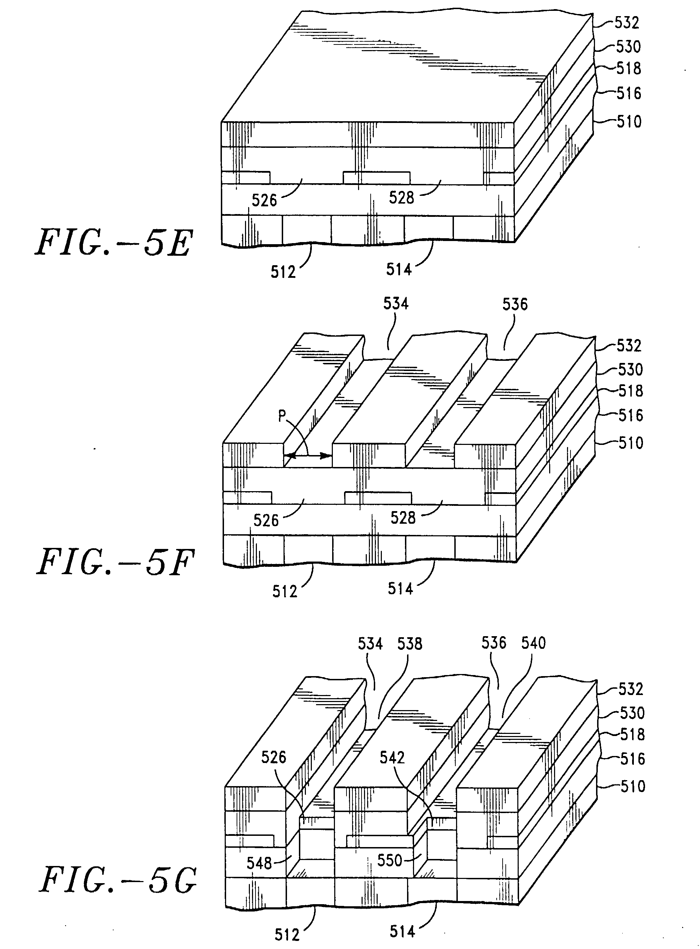

Via patterns 522 and 524 are anisotropically etched through second dielectric layer 518, forming via patterns 526 and 528 in layer 518, after which mask layer 520 is removed, see FIG. 5D. In a subsequent processing step, shown in FIG. 5E, a third dielectric layer 530 is deposited on second dielectric layer 518 and inside via patterns 526 and 528 of layer 518. Second and third dielectric layers 518 and 530 respectively have dissimilar etching characteristics. Preferably, first and third dielectric layers 516 and 530 have similar etching characteristics. The expression "similar etching characteristics" of two or more materials as defined herein, includes etching properties of these materials such that the materials are capable of being etched at similar etching rates in a particular etch chemistry. A second mask layer 532 is deposited on dielectric layer 530. The dielectric and mask layers described in connection with FIGS. 5A - 5E, can be deposited by any of the methods which are well known to those of ordinary skill in the art.

As depicted in FIG. 5F, mask layer 532 is developed to form trench patterns 534 and 536 which are aligned with substrate lines 512 and 514 respectively. These trench patterns, having a width P, provide the etch masks for dual damascene interconnect line trenches. Trench patterns 534 and 536 are anisotropically etched through third dielectric layer 530 wherein second dielectric layer 518 is the etch stop, as shown in FIG. 5G. forming trenches 538 and 540 respectively. This anisotropic etching step also removes third dielectric layer material which is present in those portions of via patterns 526 and 542 which are contained within the trench patterns. When the via pattern is aligned with the corresponding trench. such as via pattern 526 (FIG. 5G) the via pattern is opened across the entire width of the trench. When the via pattern is misaligned, such as pattern 528, it may not be possible to open the via pattern across the entire width of the trench depending on the width of the via pattern and the extent of the misalignment. The structures illustrated in FIGS. 5F and 5G show that the misalignment of via pattern 528 results in the formation of a reduced via pattern 542. It is noted that width P of trench pattern 534 is measured at a point close to the position of underlying via pattern 526.

Anisotropic etching is utilized to etch the via patterns through first dielectric layer 516, forming via holes 548 and 550 as depicted in FIG. 5G. The anisotropic via hole etching process can be a continuation of the anisotropic trench etching process where layers 516 and 530 comprise the same material or where these layers have similar etching characteristics, provided that second dielectric layer 518 is an etch stop in this process. The etch chemistry for etching the via holes needs to be different from the etch chemistry for etching the trenches if first and third dielectric layers 516 and 530 have dissimilar etching characteristics.

Mask layer 532 is then removed, providing the structure shown in FIG. 5H which includes trenches 538 and 540 extending through layer 530, and via holes 548 and 550 extending through layers 516 and 518. The trenches and via holes are simultaneously filled with a conductive material such as a metal, creating novel dual damascene structures 552 and 554 (FIG. 51) including interconnect lines 556 and 558, and via plugs 560 and 562 respectively. Excess conductive material is removed from the surface of layer 530, for example by planarizing using CMP (chemical-mechanical polishing) or by etch-back, using any of the methods which are well known to those of ordinary skill in the art. FIGS. 5H and 5I show that misalignment of the novel rectangular via pattern results in a via hole and a via plug having a reduced width compared with the width of the corresponding trench and interconnect lines. However, the inventive rectangular via pattern results in less via width reduction due to misalignment, than a conventional square via pattern. The inventive technique utilizing the novel via patterns provides complete or partial compensation for misalignment between etch masks, depending on the width of the novel via pattern and the extent of the misalignment, thereby forming novel misalignment tolerant dual damascene structures. The rectangular via pattern eliminates via width reduction which is caused by misalignment, when the width of rectangular pattern equals (not shown) or exceeds (not shown) the extent of the misalignment. It will be noted that novel via hole 550 (FIG. 5H) provides complete or partial misalignment without widening trench 540, because the novel via holes can only be formed within the trench pattern, This technique is therefore suitable even if the via pattern width extends to half the distance between adjacent trench patterns. Consequently, novel via plug 562 (FIG. 5I) provides complete or partial misalignment compensation of dual damascene structures without widening interconnect line 558, thereby preventing electrical shorts between adjacent interconnect lines.

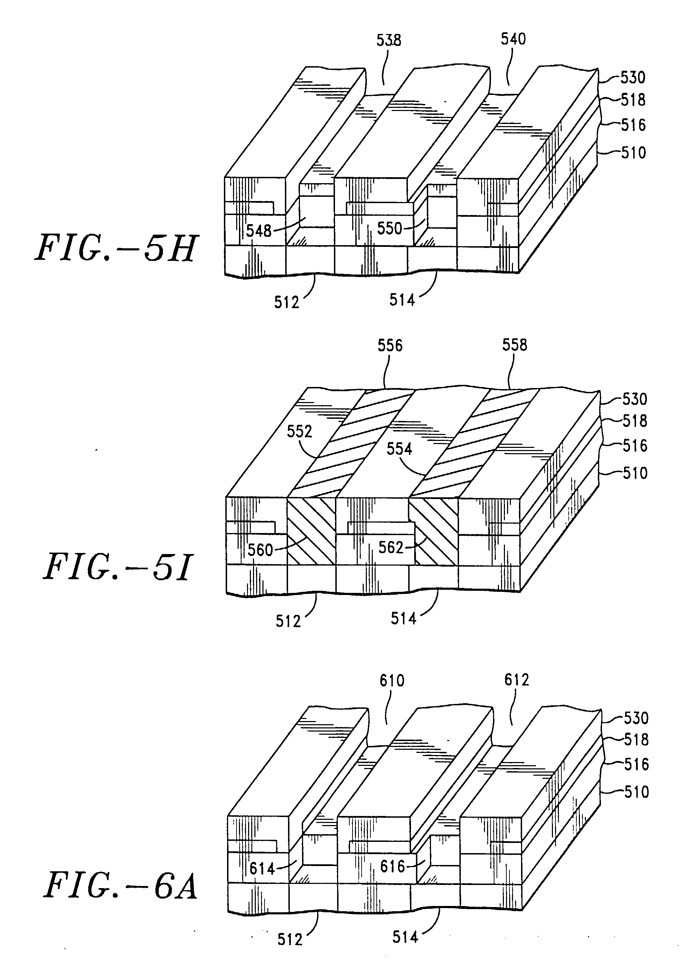

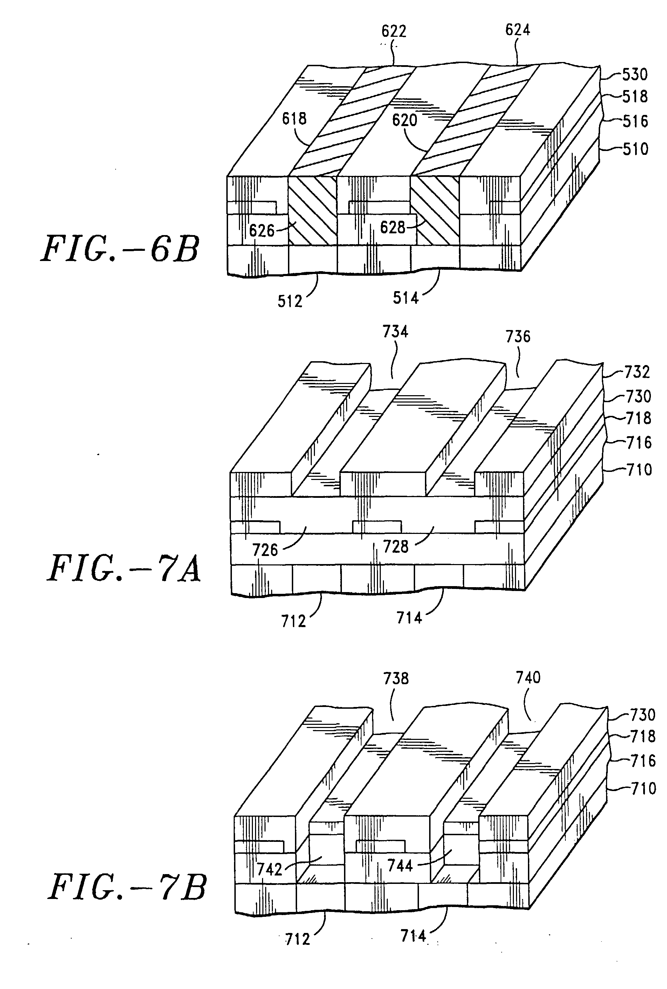

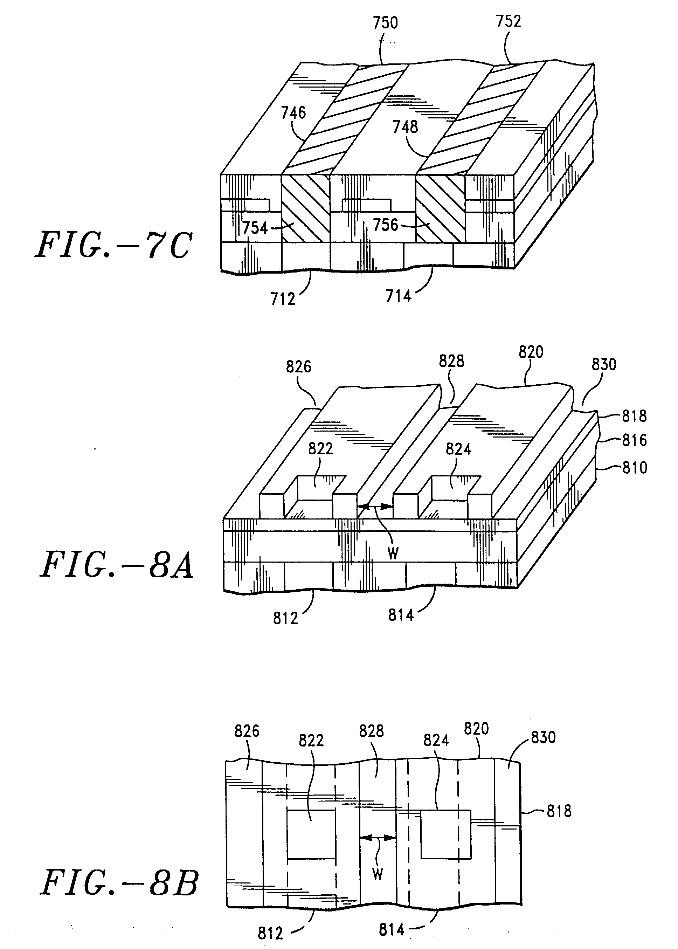

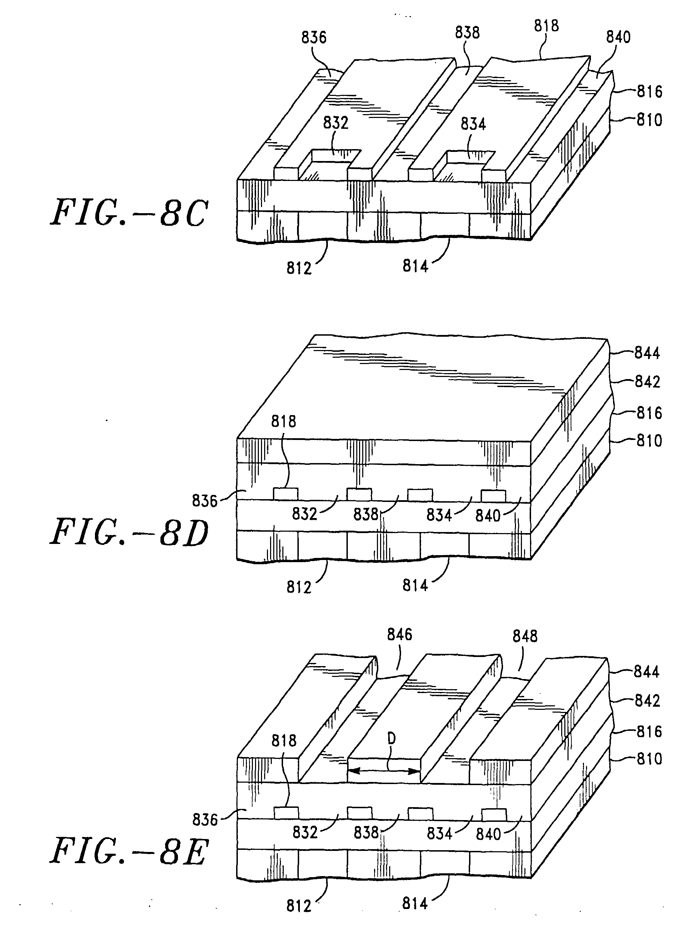

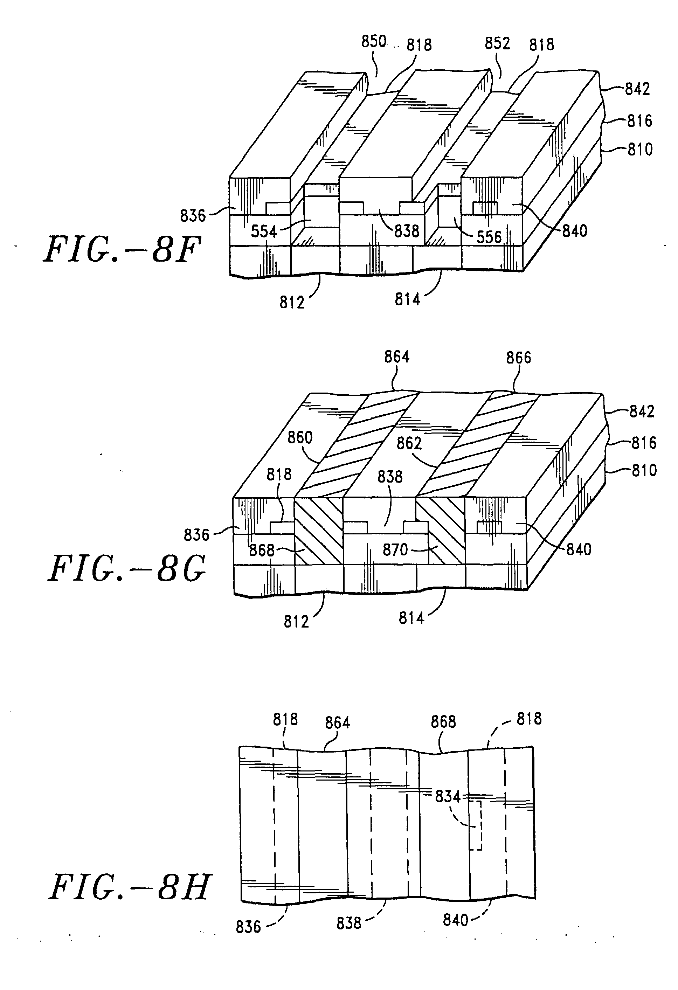

An alternate embodiment of the inventive technique described in connection with FIG. 5A - 5I is illustrated in fabricated structures shown in FIGS. 6A and 6B. In this technique, the trenches are anisotropically etched through the third dielectric layer, similar to the technique shown in FIG. 5H. This is followed by anisotropic etching of the trenches through second dielectric layer 518, as shown in FIG. 6A, forming trenches 610 and 612 extending through layers 518 and 530. Via holes 614 and 616 of this structure extend through layer 516. The present technique is advantageously employed if a cap or passivation layer (not shown) is interposed between the substrate and the first dielectric layer. Where a cap layer is employed, the anisotropic etching process for etching the trenches through layer 518 can also be used to simultaneously etch the via holes through the cap layer, providing the cap layer and layer 518 have similar etching characteristics. The trenches and via holes can be simultaneously filled with a conductive material resulting in dual damascene structures 618 and 620 shown in FIG. 6B, having interconnect lines 622 and 624 and via plugs 626 and 628. The advantages of the inventive techniques described in connection with FIGS. 6A and 6B are similar to those described in connection with FIGS. 5A - 5I. Additionally, absence of dielectric layer 518 under lines 622 and 624 result in a reduced capacitance of the structure as compared with structures having this layer underneath the interconnect lines. The dielectric, cap and mask layers described in connection with FIGS. 6A and 6B, can be deposited by any of the methods which are well known to those of ordinary skill in the art.

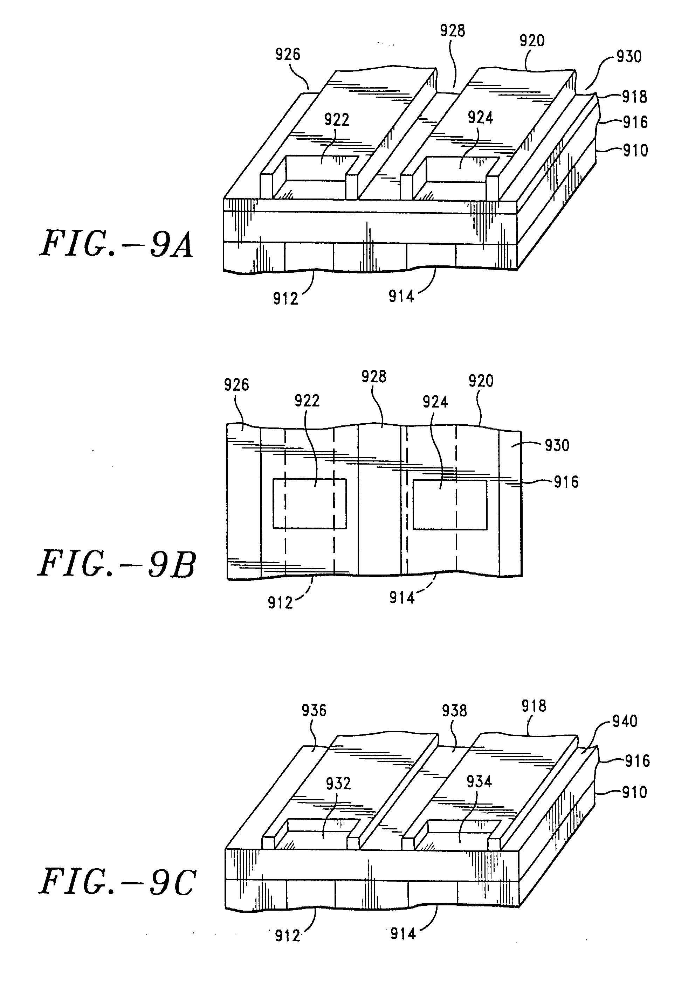

The misalignment tolerant features of the present invention are further illustrated in FIGS. 7A - 7C. The structure shown in FIG. 7A includes a substrate layer 710 having interconnect lines 712 and 714, a first dielectric layer 716, a second dielectric layer 718 having novel rectangular via patterns 726 and 728, a third dielectric layer 730 and a mask layer 732 having trench patterns 734 and 736. The materials and processes for fabricating the structure shown in FIG. 7A are similar to those of the structure depicted in FIG. 5F. Trench 734 (FIG. 7A) and novel via pattern 726 are aligned with interconnect line 712. Trench 736 is misaligned with interconnect line 714 while novel via pattern 728 is aligned with this interconnect line. By comparison, trench 536 show in FIG. 5F is aligned with interconnect line 514. while the corresponding novel via pattern 528 is misaligned with line 514. The dimensions of via patterns 726 and 728 are similar to those of via patterns 526 and 528, i.e. the width of each via pattern exceeds the width of the overlaying trench by at least 0.02µ. Trenches 738 and 740 (FIG. 7B), and via holes 742 and 744 are formed in the structure using techniques similar to those described in connection with FIGS. 5G and 5H. The trenches and via holes are simultaneously filled with a conductive material, such as a metal, forming novel dual damascene structures 746 and 748 (FIG. 7C) including interconnect lines 750 and 752, and via plugs 754 and 756. The inventive technique employing the novel via patterns provides complete or partial compensation for the misalignment depending on the width of the novel via pattern and the extent of the misalignment similar to the misalignment tolerance described in connection with FIGS. 5A - 6B.

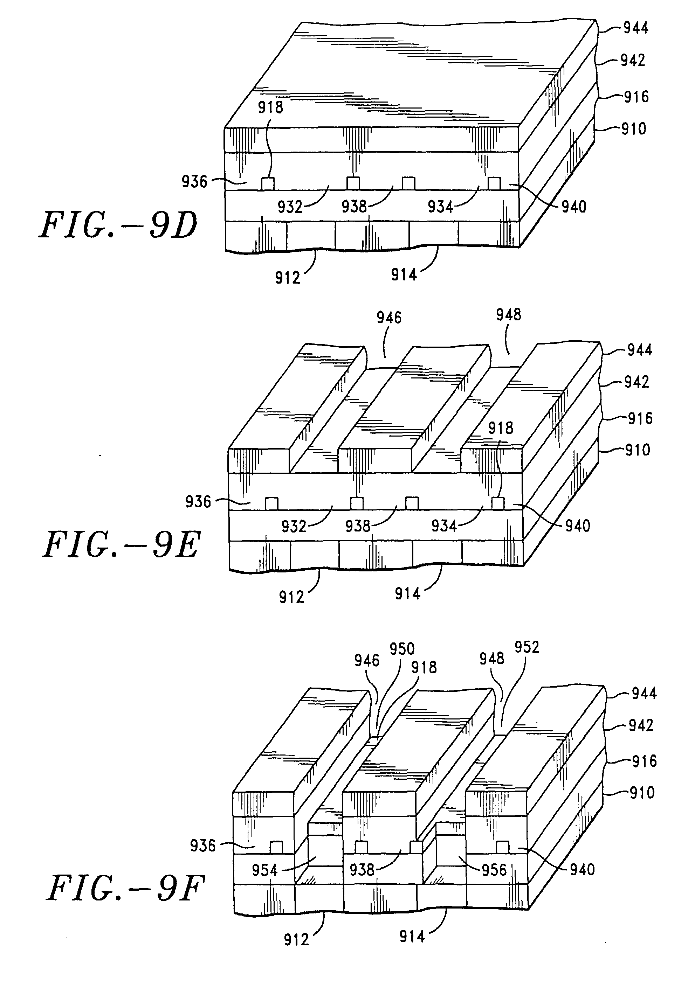

An alternate embodiment of the present invention is illustrated in fabricated structures, such as the IC structures shown in FIGS. 8A - 8H. The structure shown in FIG. 8A includes substrate 810 having interconnect lines 812 and 814, first and second dielectric layers 816 and 818 and first mask layer 820. These layers and interconnect lines are similar to those described in connection with FIG. 5A. Mask layer 820 is developed for square via patterns 822 and 824 (FIG. 8A) which are similar to prior art via patterns, such as via patterns 322 and 324 described in connection with FIGS. 3B and 3C. As depicted in FIGS. 8A and 8B, via pattern 822 is aligned with underlying substrate interconnect line 812, while square via pattern 824 is misaligned with substrate line 814. Simultaneously with the formation of the via patterns, mask layer 820 is developed for sacrificial etch patterns 826, 828 and 830. The expression "sacrificial etch pattern" as defined herein, includes one or more etch patterns which are used to form one or more sacrificial etch segments in an etch stop layer between adjacent dual damascene interconnect lines, as will be described more fully in connection with FIGS. 8C - 8H. Sacrificial etch pattern 828 has a width W, as shown in FIGS. 8A and 8B. Advantageously, the novel techniques employed in the present embodiment provide for etch masks wherein the mask design includes the via patterns and the sacrificial etch patterns. These techniques prevent misalignment between via patterns and sacrificial etch patterns.

As depicted in FIG. 8C, the via patterns and the sacrificial etch patterns are transferred to second dielectric layer 818, forming via patterns 832 and 834, and novel sacrificial etch segments 836, 838 and 840, after which etch mask layer 820 is removed. Via pattern 832 is aligned with underlying line 812, while via pattern 834 is misaligned with underlying line 814. A third dielectric layer 842 is deposited on the remaining segments of layer 818, see FIG. 8D. The deposition of layer 842 also fills via patterns 832 and 834, and sacrificial etch segments 836, 838 and 840 with layer 842 material. A second mask layer 844 is deposited on layer 842. Trench patterns 846 and 848 (FIG. 8E) are formed in mask layer 844 to provide the etch masks for dual damascene interconnect line trenches, wherein D is the distance between these trench patterns as measured near via patterns 832 and 834. These trench patterns overlay the respective via patterns and the remaining segments of layer 818. In other words, the trench patterns do not overlay the sacrificial etch segments. Trench patterns 846 and 848 are employed to anisotropically etch trenches 550 and 552, and to subsequently anisotropically etch via holes 554 and 556, after which mask layer 844 is removed, see FIG. 8F. This etching process is similar to the techniques which are described in connection with FIGS. 5G and 5H. The via holes and trenches are simultaneously filled with a conductive material, such as a metal, thereby fabricating dual damascene structures 860 and 862, as shown in FIG. 8G. These structures include interconnect lines 864 and 866, and via plugs 868 and 870 respectively. The dielectric and mask layers described in connection with FIGS. 8A - 8H, can be deposited by any of the methods which are well known to those of ordinary skill in the art.

As illustrated in FIGS. 8G and 8H, novel sacrificial etch segments 836, 838 and 840 provide gaps in etch stop layer 818 between the interconnect lines of the dual damascene structures, resulting in a reduced capacitance between the dual damascene structures. Alternatively, etch stop layer 818 can be removed (not shown) from trenches 850 and 852 (FIG. 8F), using techniques similar to those described in connection with FIGS. 6A and 6B. This latter technique is suitable for forming dual damascene structures (not shown) having sacrificial etch segments in the etch stop layer between the dual damascene interconnect lines and having no etch stop layer underneath the lines, resulting in a further reduction in the capacitance between the dual damascene structures of the present invention.

Layer 818 is an etch stop for the etching process which is used to form trenches 850 and 852 (FIG. 8F). Consequently, sacrificial etch segments 836, 838 and 840 should be positioned such that the trench patterns overlay layer 818 rather than these sacrificial segments. On the other hand, the sacrificial etch segments should form the widest possible gaps between adjacent trench patterns in order to provide the greatest reduction in capacitance between the resulting dual damascene structures. Proper positioning ofthe novel sacrificial etch patterns relative to the trench pattens is further complicated by the possible occurrence of etch mask pattern misalignments. It is well known to those of ordinary skill in the art that pattern misalignments occur from time to time in the fabrication of IC structures. Preferably, misalignment tolerant techniques should be utilized to compensate for these misalignments by providing a sacrificial etch pattern wherein the pattern width is smaller than the distance between the corresponding metal lines. For example, with reference to FIGS. 8A, 8B and 8E, width W of sacrificial etch pattern 828 is preferably smaller than distance D between trench patterns 846 and 848 in order to provide a misalignment tolerant sacrificial etch pattern. It is noted that the width of a sacrificial etch segment is similar to the width of the corresponding sacrificial etch pattern and that the distance between adjacent dual damascene line trenches of the present invention is similar to the distance between the corresponding trench patterns. Preferably, D exceeds W by a measure which equals or exceeds the extent of the misalignment. Typically D exceeds W by at least 0.02µ. Commonly used manufacturing and quality assurance methods can, for example, be utilized to determine the size and statistical frequency of these misalignments for any specific fabrication process.

In summary, the embodiment of the present invention described in connection with FIGS. 8A - 8H is illustrative of the novel technique wherein one or more sacrificial etch segments are provided in an etch stop layer between adjacent dual damascene structures, in order to reduce the capacitance typically resulting from the presence of etch stop layer material. This inventive technique includes forming one or more sacrificial etch segments, such as sacrificial etch segment 828 (FIGS. 8A and 8B), in a dielectric stack. Trenches are formed in the stack on the dielectric layer, such that the sacrificial etch segment is positioned between the trenches. A via hole is formed underneath each trench. The via holes communicate with their respective trenches and can for example, communicate with an underlying substrate. Distance D between two adjacent trenches, preferable exceeds width W of the sacrificial etch segment in order to compensate for possible misalignment between etch mask patterns. More preferably, D exceeds W by a measure M of at least 0.02µ. The trenches and via holes are simultaneously filled with a conductive material, such as a metal, to form adjacent dual damascene structures having a gap in the etch stop layer between the structures. Alternatively, the trenches can additionally be etched through the etch stop layer.

Another embodiment of the present invention, illustrated in FIGS. 9A - 9H, combines the novel rectangular via patterns shown in FIGS. 5B - 7C with the novel sacrificial etch patterns and novel sacrificial etch segments depicted in FIGS. 8A - 8H. The structure illustrated in FIG. 9A includes a substrate 910 having substrate interconnect lines 912 and 914, a first dielectric layer 916, a second dielectric layer 918 and a first mask layer 920. The substrate, dielectric and mask layers are similar to those depicted in FIG. 5A. Mask layer 922 is developed to form novel rectangular via patterns 922 and 924, similar to via patterns 522 and 524 shown in FIGS. 5B and 5C. Via pattern 922 is aligned with line 912, while via pattern 924 is misaligned with line 914. Simultaneously, first mask layer 920 is developed to form novel sacrificial etch patterns 926, 928 and 930, similar to those described in connection with FIGS. 8A and 8B.

As shown in FIG. 9C, via patterns 922 and 924, and sacrificial etch patterns 926, 928 and 930 are transferred to second dielectric layer 918 through anisotropic etching similar to the techniques employed for fabricating the structures shown in FIGS. 5D and 8C. This etching process forms via patterns 932 and 934 as well as sacrificial etch segments 936, 938 and 940. Subsequently, mask layer 920 is removed, as depicted in FIG. 9C. A third dielectric layer 942 (FIG. 9D) is then deposited on layer 916 and in via patterns and sacrificial etch segments 932, 934, 936, 938 and 940 respectively. Trench patterns 946 and 948 for dual damascene interconnect line trenches are formed in a second etch mask layer 944 deposited on layer 942, as depicted in FIG. 9E. Trench 946 is aligned with underlying substrate interconnect line 912, while trench 948 is aligned with underlying line 914. Trench patterns 946 and 948 are anisotropically etched through dielectric layer 942 forming trenches 950 and 952 respectively, see FIG. 9F. The remaining segments of second dielectric layer 918 form an etch stop for the trench etching process. Via holes 954 and 956 are anisotropically etched, after etching the trenches as described in connection with FIG. 5G. Mask layer 944 is removed, as shown in FIG. 9G. Via holes 954 and 956, and trenches 950 and 952 are simultaneously filled with a conductive material, such as a metal, forming dual damascene structures 954 and 956 (FIG. 9H) having interconnect lines 958 and 960, and via plugs 962 and 964 respectively. Preferably, the distance between the trench patterns exceeds the width of sacrificial etch pattern as described in connection with FIGS. 8A - 8H, in order to provide misalignment tolerant sacrificial etch segments.

Novel via hole 956 (FIG. 9G) and novel via plug 964 (FIG. 9H) provide misalignment tolerant features similar to those described in connection with novel via hole 550 (FIG. 5H) and via plug 562 (FIG. 5I). Also, novel sacrificial etch segments 936, 938 and 940 (FIGS. 9G and 9H) provide similar capacitance reduction as previously described in connection with novel sacrificial etch segments 836, 838 and 840 (FIGS. 8G and 8H). The novel technique described in connection with FIGS. 9A- 9H thus combines the advantages of the novel rectangular via patterns described in connection with FIGS. 5A - 7C with the advantages of providing sacrificial etch segments as described in connection with FIGS. 8A - 8H. The dielectric and mask layers described in connection with FIGS. 9A - 9H, can be deposited by any of the methods which are well known to those of ordinary skill in the art.

Advantageously, the inventive techniques for forming novel sacrificial etch segments employ only two etch masks. A first etch mask which is designed to include the via patterns and the sacrificial etch patterns, while a second mask provides the trench patterns for etching the dual damascene line trenches. The utilization of only two etch masks minimizes fabrication cost and pattern misalignments. The inventive techniques which are described in connection with FIGS. 5A - 9H utilize photoresist masks. However, it will be understood that the invention is equally operable when hard masks or combinations of photoresist masks and hard masks are used providing that the mask material has a low etch rate for the etching procedures used in etching the dielectric layers of the inventive structures.

While the via holes and via plugs of the present invention illustrated in FIGS. 5A - 9H have typically been described and illustrated as making contact with a substrate interconnect line, the invention is equally operable when the via holes and via plugs make contact with one or more contact elements. A contact element as defined herein includes a conductive component with provides a low resistivity contact between the via plug of a dual damascene structure and circuit elements, interconnects or semiconductor material of a structure, such as an IC structure.

The embodiments illustrated in FIGS. 5A - 9H are suitable for employing a variety of dielectric stacks, providing that the etching characteristics of the materials meet the criteria which are described in connection with these embodiments. Examples of suitable dielectric stack materials for the second dielectric layer include oxides such as PECVD (plasma-enhanced chemical vapor deposition) SiO₂ and F-SiO_{2,} nitrides such as CVD (chemical vapor deposition) silicon nitride and silicon carbide, while suitable dielectric materials for the first and third dielectric layers include materials having a low dielectric constant, such as polymers, for example amorphous fluorinated carbon based materials, spin-on dielectric polymers such as fluorinated and non-fluorinated poly(arylene) ethers (commercially known as FLARE 1.0 and 2.0, which are available from Allied Signal Company), poly(arylene) ethers (commercially known as PAE 2-3, available from Schumacher Company), divinyl siloxane benzocyclobutane (DVS-BCB) or similar products and aero-gel. These dielectric materials are well known to those of ordinary skill in the art. The oxides, nitrides or carbides and the polymers have dissimilar etching characteristics because the etch chemistries used for polymer etching, such as O₂-based etch chemistries, are highly selective with respect to SiO₂, nitride or carbide. On the other hand, CHFₓ-based chemistry typically used for etching SiO₂ nitride or carbide is highly selective with respect to polymer.

Additionally, suitable dielectric stacks meeting the above described etch criteria include stacks wherein the second dielectric layer comprises silicon carbide or silicon nitride and wherein the first and third dielectric layers comprise Black Diamond™, available from Applied Materials, Inc. and described in commonly assigned U.S. Pat. application Serial No. 09/114,682, filed on July 13, 1998. Silicon nitride or silicon carbide dielectric materials and Black Diamond™ have dissimilar etching characteristics.

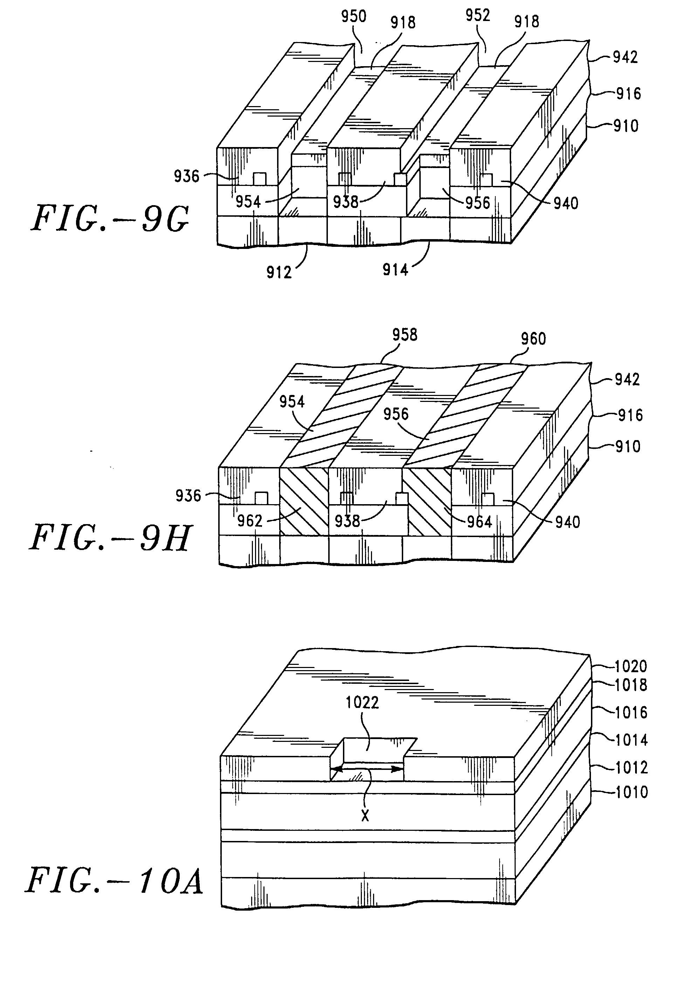

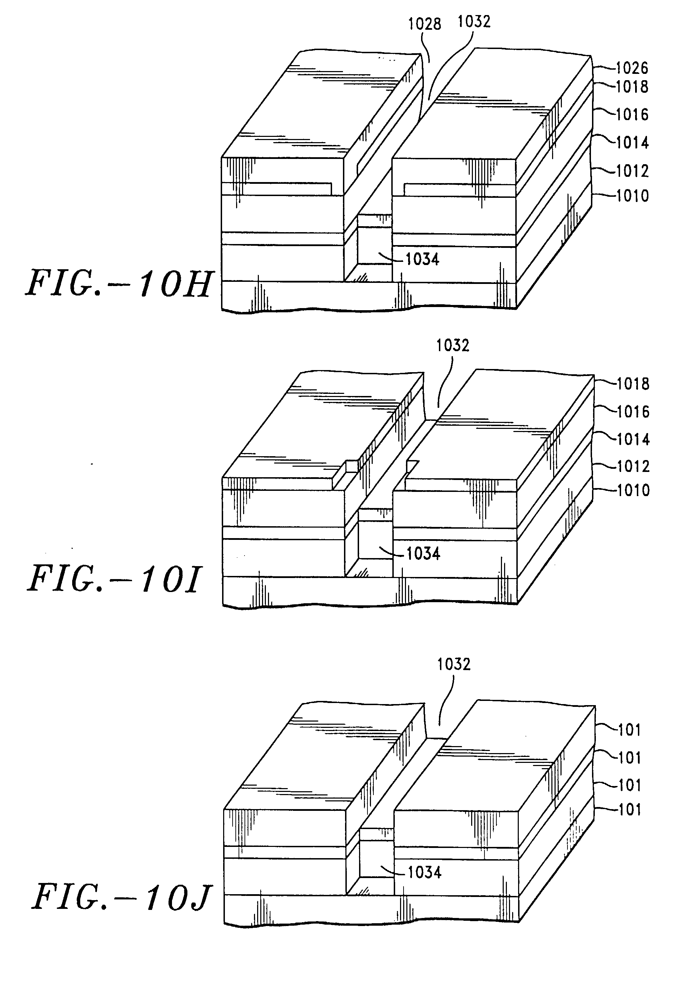

An additional embodiment of the present invention is illustrated in FIGS. 10A - 10K, showing fabricated structures, such as IC structures, adapted for the formation of novel dual damascene structures. The structure shown in FIG. 10A utilizes a first dielectric layer 1012 which is deposited on a substrate, such as a semiconductor substrate 1010. A second dielectric layer 1014 is deposited on layer 1012. Subsequently, a third dielectric layer 1016 is deposited on layer 1014, followed by the deposition of a hard mask layer 1018. A first photoresist layer 1020 is deposited on hard mask layer 1018. First and third dielectric layers 1012 and 1016 have similar etching characteristics while second and third dielectric layers 1014 and 1016 have dissimilar etching characteristics. Also, first and second dielectric layers 1012 and 1014 have dissimilar etching characteristics. Second dielectric layer 1014 and hard mask layer 1018 have similar etching characteristics. The dielectric, hard mask and photoresist layers of the structure depicted in FIG. 10A can be deposited by any of the methods which are well known to those of ordinary skill in the art.

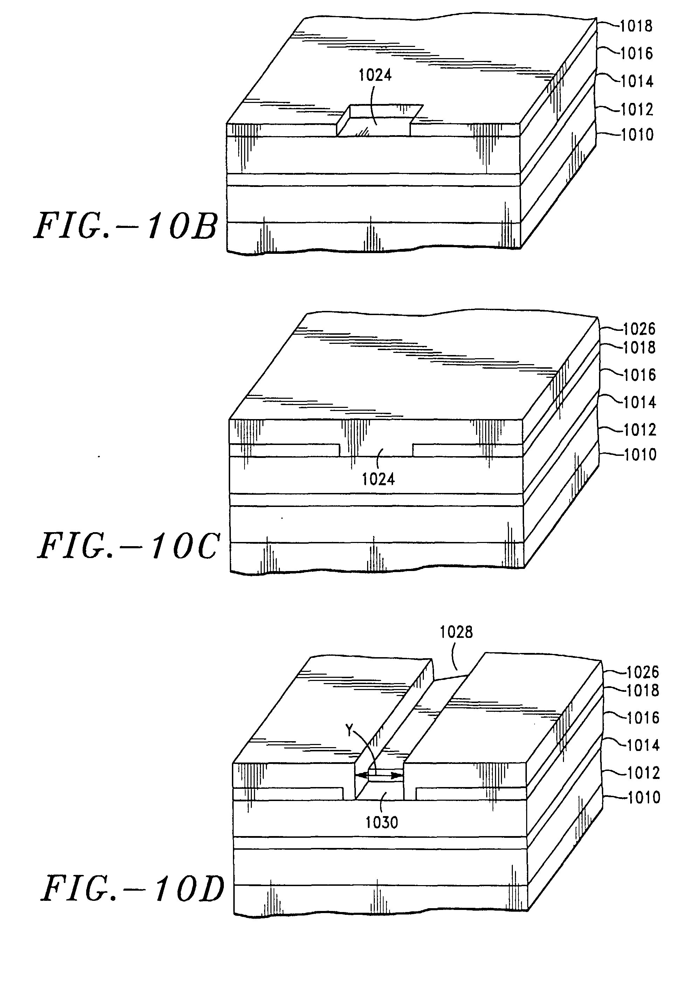

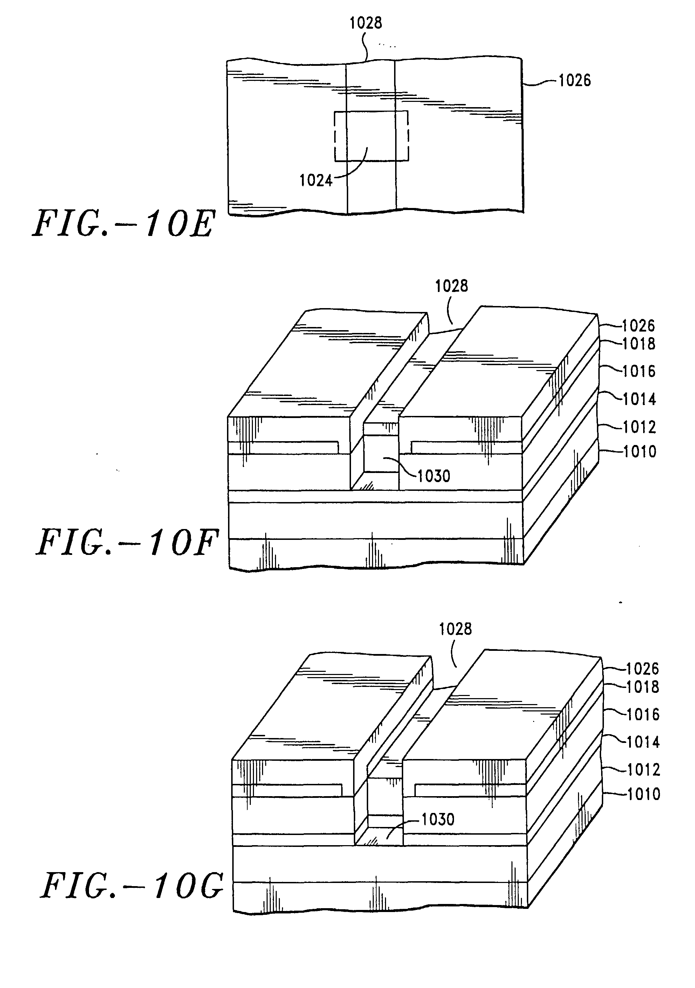

As shown in FIG. 10A, a novel rectangular via pattern 1022 is developed in resist 1020. The configuration is similar to the configuration of via patterns 522 and 524, described in connection with FIGS. 5B and 5C, i.e. the width of via pattern 1022 exceeds the width of the overlaying trench pattern, preferably by at least 0.02µ. Width X of via pattern 1022 (FIG. 10A) is defined in a similar manner as width T of via pattern 522 (FIG. 5C), while width Y of trench pattern 1028 (FIG. 10D) is comparable to width P of trench pattern 534 (FIG. 5F). In other words, width X (FIG. 10A) of via pattern 1022 is greater than width Y of trench pattern 1028 (FIG. 10D), while the length of the via pattern is similar to the width of the trench pattern. Via pattern 1022 is transferred to hard mask layer 1018 through anisotropic etching, forming via pattern 1024 in layer 1018, after which first resist layer 1020 is stripped, see FIG. 10B. A second photoresist layer 1026 (FIG. 10C) is deposited on hard mask layer 1018 and inside via pattern 1024. Second resist layer 1026 is developed for a trench pattern 1028 (FIGS. 10D and 10E) for the fabrication of a dual damascene line trench, This process also results in removing resist 1026 from the portion of via pattern 1024 underlying trench pattern 1028, thereby forming via pattern 1030 (FIG. 10D). Via pattern 1030 is anisotropically etched through layer 1016, see FIG. 10F, wherein second dielectric layer 1014 is an etch stop. Next, trench pattern 1028 is anisotropically etched through hard mask layer 1018, while simultaneously anisotropically etching via pattern 1030 through second dielectric layer 1014, as depicted in FIG. 10G.

French pattern 1028 and via pattern 1030 are simultaneously anisotropically etched through dielectric layers 1016 and 1012 (FIG. 10H) forming trench 1032 and via hole 1034 respectively. Trench 1032 extends through layer 1016, while via hole 1034 extends through layers 1012 and 1014 to substrate 1010. Next, resist 1026 is stripped, see FIG. 101. This is followed by the removal of hard mask layer 1018 (FIG. 10J). As shown in FIG. 10K, trench 1032 and via hole 1034 are simultaneously filled with a conductive material, such as a metal, forming novel dual damascene structure 1036 including interconnect line 1038 and via plug 1040. The novel technique of the present embodiment illustrated in FIGS. 10A - 10K, provides novel rectangular via patterns which compensate partly or completely for misalignment between the via pattern and the trench pattern without causing any widening of the line trench and the interconnect line, because the via holes can only be formed within the trench pattern. This technique is therefore suitable even if the via pattern width extends to half the distance between adjacent trench patterns. Consequently, the via patterns of the present invention result in via plugs which do not cause an electrical short between closely spaced interconnect lines of dual damascene structures. Also, these via patterns can be fabricated such that the length of the via pattern does not exceed the width of the corresponding dual damascene trench pattern thus resulting in via plugs having a cross sectional length dimension which does not exceed the width of the corresponding interconnect line, thereby maximizing the number of via plugs which can be fabricated on the corresponding interconnect line.

A variety of dielectric stacks can be utilized for the embodiment illustrated in FIGS. 10A - 10K, providing that the etching characteristics of the materials meet the criteria which are described in connection with these embodiments. Examples of suitable dielectric stack materials for the second dielectric layer and hard mask layer include oxides such as PECVD SiO₂ and F-SiO₂ as well as silicon carbide, while suitable dielectric materials for the first and third dielectric layers include materials having a low dielectric constant, such as polymers, for example amorphous fluorinated carbon based materials, spin-on dielectric polymers such as fluorinated and non-fluorinated poly(arylene) ethers (commercially known as FLARE 1.0 and 2.0, which are available from Allied Signal Company), poly(arylene) ethers (commercially known as PAE 2-3, available from Schumacher Company), divinyl siloxane benzocyclobutane (DVS-BCB) or similar products and aero-gel. These dielectric materials are well known to those of ordinary skill in the art. The oxides, nitrides or carbides and the polymers have dissimilar etching characteristics because etch chemistries used for polymer etching, such as O₂-based etch chemistries, are highly selective with respect to SiO₂, nitride or carbide. On the other hand, CHFₓ-based chemistry typically used for etching SiO₂, nitride or carbide is highly selective with respect to polymer. Suitable dielectric stacks also include stacks wherein the second dielectric layer and the hard mask layer comprise silicon nitride or silicon carbide, while the first and third dielectric layers comprise Black Diamond™. Another example of a suitable dielectric stack for the structures shown in FIGS. 10A - 10K includes second dielectric layer and mask layer materials comprising nitride, such as CVD (chemical vapor deposition) silicon nitride or silicon carbide, while dielectric materials for first and third dielectric layers 712 and 716 include oxides, such as PECVD SiO₂ and F-SiO₂.

Embodiments of the present invention illustrated in FIGS. 5A - 7C and 9A - 10K have been described by means of rectangularly shaped via patterns. It will be understood that the invention is also operable when other via shapes such as ellipse and oval are utilized, provided that these shapes, at their widest points, exceed the width of the corresponding damascene line trench. As is well known by those of ordinary skill in the art, a rectangular etch pattern can result in an etched hole having rounded corners at the bottom, approximating an ellipse or oval shape.

Additional embodiments (not shown) of the present invention include depositing a liner inside the via holes and trenches of the IC structures shown in FIGS. 5H, 6A, 7B, 8F, 9G and 10J. The lined via holes and trenches are then simultaneously filled with a conductive material to form the dual damascene structures of the present invention. Suitable liner materials include adhesion promoters and diffusion barrier materials. For example suitable liner materials for Cu or Cu alloy containing damascene structures of the present invention include CVD or PVD (physical vapor deposition) TiN, WN, Ta and TaN. Examples of suitable liner materials for Al. Al alloy, W, or W alloy containing damascene structures include PVD Ti/TiN.

Suitable semiconductor materials for use in semiconductor substrates of the present invention include silicon, germanium, silicon/germanium alloys, gallium arsenide and indium/gallium/arsenide/phosphide. Typically, dual damascene structures of the present invention contact a metallized line of the semiconductor substrate. Suitable conductive materials for filling the damascene trenches and via holes of the present invention include metals such as Cu, Ag. Al, W, their alloys and mixtures of these metals with or without alloys. While the embodiments of the invention are described and illustrated using metal interconnect lines and metal damascene structures, the invention is equally operable when conductive materials other than metals are used. Suitable conductive materials include metallic and nonmetallic superconductors, i.e. materials having zero direct current resistance at or below their superconducting transition temperature, such as metallic nickel/germanium and nonmetallic yttrium/barrier/copper oxides. Suitable techniques for simultaneously filling damascene trenches and via holes include CVD, PVD, electroplating and electroless plating. These techniques are well known to those of ordinary skill in the art. The various etching techniques and etching chemistries employed in the embodiments of the present invention include techniques and chemistries which are well known to those of ordinary skill in the art. Also, it will be understood that it is necessary to clean or prepare the surface of the structure prior to the deposition of any layer in any subsequent fabrication step, using surface preparation methods and materials which are well known to those of ordinary skill in the art. It will also be understood that methods for removing resist include conventional dry and wet methods.

Embodiments of the present invention are illustrated herein using IC structures containing one or two dual damascene structures. It will be understood that the inventive techniques are equally operable for the fabrication of IC structures containing multiple dual damascene structures throughout the IC structure.

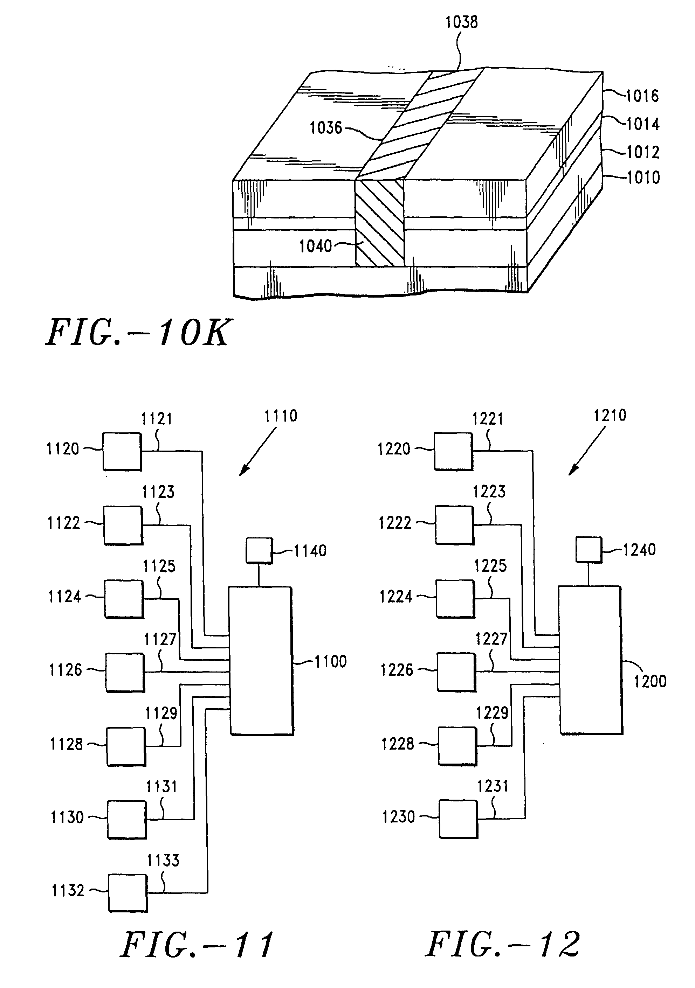

The novel dual damascene fabrication techniques of the present invention require a sequence of processing steps. Each processing step can be performed at a fabrication station. All or some of the fabrication stations and their respective processing steps can be integrated by means of a novel apparatus including a controller 1100 illustrated in FIG. 11. Controller 1100 is adapted for controlling a number of fabrication stations which are utilized in the formation of fabricated structures, such as the IC structures described in connection with FIGS. 5A - 7C. As illustrated in FIG. 11, a novel manufacturing system 1110 for fabricating IC structures includes controller 1100 and a plurality of fabrication stations: 1120, 1122, 1124, 1126, 1128, 1130 and 1132. Additionally, system 1110 has operative links 1121, 1123, 1125, 1127, 1129, 1131 and 1133 which provide connections between controller 1100 and fabrication stations 1120, 1122, 1124, 1126, 1128, 1130 and 1132 respectively. The novel apparatus includes a data structure such as a computer program which causes controller 1100 to control the processing steps at each of the fabrication stations and to, optionally, regulate the sequence in which fabrication stations are used in order to form the novel structures.

Examples of suitable controllers include conventional computers and computer systems including one or more computers which are operably connected to other computers or to a network of computers or data processing devices. Suitable computers include computers commonly known as personal computers. The data structure which is used by controller 1100 can be stored on a removable electronic data storage medium 1140 (FIG. 11), such as computer floppy disks, removable computer hard disks, magnetic tapes and optical disks, to facilitate the use of the same data structure at different manufacturing locations. Alternatively, the data structure can be stored on a non-removable electronic data storage medium, including a medium positioned at a location which is remote (not shown) from controller 1100, using such data storage devices as are well known to those or ordinary skill in the art. The data structure can be communicated from a remote location to controller 1100 using communicating techniques which are well known to those of ordinary skill in the art including hard wire connections, wireless connections and data communication methods utilizing one or more modems or techniques using one or more computers commonly known as servers. The data storage medium can be operably connected to the controller using methods and device components which are well know to those of ordinary skill in the art. Examples of suitable fabrication stations for manufacturing system 1110 include the stations shown in Table A.

**Table A**

| Station | Processing Stop |
|---|---|
| 1120 | depositing a first dielectric layer on a substrate |
| 1122 | depositing a second dielectric layer on the first dielectric layer |
| 1124 | depositing a first mask layer having a via pattern on the second dielectric layer |
| 1126 | anisotropically etching the via pattern through the second dielectric layer |
| 1128 | removing the first mask layer |
| 1130 | depositing a third dielectric layer on the second dielectric layer |
| 1132 | depositing a second etch mask having a trench pattern overlaying the via pattern on the third dielectric layer |

Additional fabrication stations can be added to manufacturing system 1110. The sequence of processing steps shown in Table A is illustrative of system 1110. However, the invention is equally operable in systems wherein a controller, such as controller 1100, causes the sequence to be altered, for example by repeating a previously executed processing step if test results indicate that this processing step should be partly or completely repeated. Alternatively, the process sequence which is controlled by a controller such as controller 1100, can include processing steps such as surface preparation which may be performed following any of the fabrication stations shown in FIG. 11 and Table A. It is also contemplated that one or more fabrication stations can be positioned at a location which is remote from the other fabrication stations in which case an additional controller or a network of controllers can be employed to control the remotely located manufacturing station. As illustrated in FIG. 11, controller 1100 is adapted to be connected to each of the manufacturing stations through operative links. Each of these links provides a bidirectional connection enabling controller 1100 to transfer commands from its data structure, such as specific operating parameters, and to receive information, such as test data, from the fabrication station. The operative links can be in the form of hard wire connections or wireless connections.

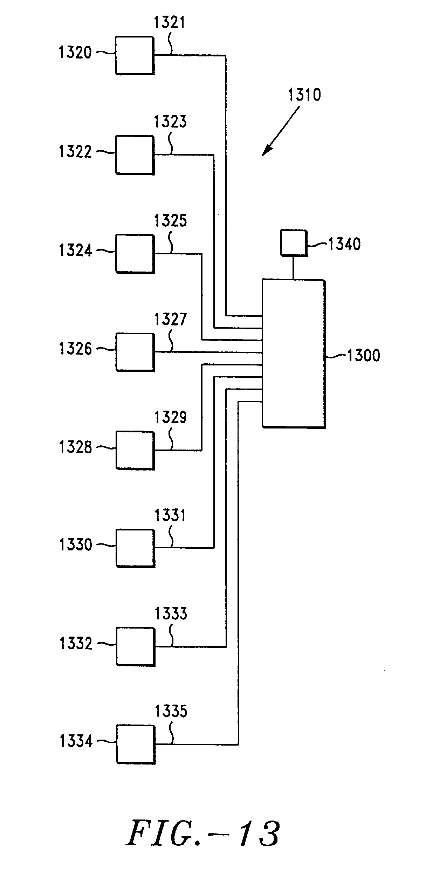

FIG. 12 depicts another embodiment of the present invention. A novel apparatus including inventive controller 1200 is adapted for controlling fabrication stations which are utilized in the formation of fabricated structures, such as IC structures described in connection with FIGS. 8A - 8H. Fabrication stations 1220, 1222, 1224, 1226, 1228 and 1230 are connected to controller 1200 through operative links 1221, 1223, 1225, 1227, 1229 and 1231 respectively. The novel apparatus includes a data structure which causes the controller to control the processing steps at each of the fabrication stations. A novel manufacturing system 1210 for manufacturing the structures exemplified in FIGS. 8A- 8H includes controller 1200, the data structure, the above manufacturing stations and the operative links. The data structure can be provided on a removable electronic storage medium 1240. The controller, the data structure, the operative links and the removable storage medium are similar to those described in connection with FIG. 11. Examples of suitable fabrication stations for manufacturing system 1210 include the stations shown in Table B.

**Table B**

| Station | Processing Step |
|---|---|
| 1220 | forming a dielectric stack including an etch stop layer |
| 1222 | forming a sacrificial etch segment in the etch stop layer |
| 1224 | forming a first trench on the etch stop layer |
| 1226 | forming a second trench on the etch stop layer |
| 1228 | forming a first via hole underlying the first trench |
| 1230 | forming a second via hole underlying the second trench |

FIG. 13 depicts another embodiment of the present invention. A novel apparatus including inventive controller 1300 is adapted for controlling fabrication stations which are utilized in the formation of fabricated structures, such as IC structures described in connection with FIGS. 10A - 10K. Fabrication stations 1320, 1322, 1324, 1326, 1328, 1330, 1332 and 1334 are connected to controller 1300 through operative links 1321, 1323, 1325, 1327, 1329, 1331, 1333 and 1335 respectively. The novel apparatus includes a data structure which causes the controller to control the processing steps at each of the fabrication stations. A novel manufacturing system 1310 for manufacturing the structures illustrated in FIGS. 10A - 10K includes controller 1300, the data structure, the above manufacturing stations and the operative links. The data structure can be provided on a removable electronic storage medium 1340. The controller, the data structure, the operative links and the removable storage medium are similar to those described in connection with FIG. 11. Examples of suitable fabrication stations for manufacturing system 1310 include the stations shown in Table C.

**Table C**

| Station | Processing Step |
|---|---|
| 1320 | depositing a first dielectric layer on a substrate |
| 1322 | depositing a second dielectric layer on the first dielectric layer |
| 1324 | depositing a fluid dielectric layer on the second dielectric layer |
| 1326 | depositing a hard mask layer on the third dielectric layer |
| 1328 | depositing a first photoresist layer having a via pattern on the hard mask layer |
| 1330 | anisotropically etching the via pattern through the hard mask layer |
| 1332 | removing the first photoresist layer |
| 1334 | depositing a second photoresist having a trench pattern overlaying the via pattern on the hard mask layer |

The invention has been described in terms of the preferred embodiment. A person of ordinary skill in the art will recognize that it would be possible to construct the elements of the present invention from a variety of means and to modify the placement of components in a variety of ways. While the embodiments of the invention have been described in detail and shown in the accompanying drawings, it will be evident that various further modifications are possible without departing from the scope of the invention as set forth in the following claims.

## Claims

1. A method of forming a structure on a substrate, the method comprising:
a) depositing a first dielectric layer on the substrate;
b) depositing a second dielectric layer on the first dielectric layer, wherein the first and second dielectric layers comprise materials having dissimilar etching characteristics;
c) depositing a first mask layer on the second dielectric layer, wherein the first mask layer includes a first via pattern having a predetermined width T;
d) anisotropically etching the first via pattern through the second dielectric layer;
e) removing the first etch mask;
f) depositing a third dielectric layer on the second dielectric layer, wherein the second and third dielectric layers comprise materials having dissimilar etching characteristics; and
g) depositing a second mask layer on the third dielectric layer, wherein the second mask layer includes a trench pattern overlaying the first via pattern and having a predetermined width P, such that T exceeds P by a predetermined measure M, whereby the first via pattern and the trench pattern are adapted for fabricating a dual damascene structure.

2. The method of claim 1 further comprising:
a) anisotropically etching the trench pattern through the third dielectric layer, thereby forming a trench and a second via pattern; and
b) anisotropically etching the second via pattern through the first dielectric layer, thereby forming a via hole extending to the substrate.

3. The method of claim 2 wherein a cap layer is interposed between the substrate and the first dielectric layer.

4. The method of claim 3 additionally comprising:
a) anisotropically etching the trench through the second dielectric layer, and
b) simultaneously anisotropically etching the via hole through the cap layer.

5. The method of claim 1 wherein the first and third dielectric layers comprise materials having similar etching characteristics.

6. The method of claim 1 wherein M is at least 0.02µ.

7. The method of claim 1 wherein the first and third dielectric layers comprise one or more dielectric materials selected from the group consisting of amorphous fluorinated carbon, organic spin-on materials, spin-on glass, aero-gel, poly(arylene) ethers, fluorinated poly(arylene) ethers and divinyl siloxane benzocyclobutane.

8. The method of claim 7 wherein the second dielectric layer comprises one or more dielectric materials selected from the group consisting of silicon oxides, silicon nitrides and silicon carbides.

9. The method of claim 1 wherein depositing a first mask layer comprises depositing a mask layer selected from the group consisting of photoresist mask layers, hard mask layers and combinations of photoresist mask layers and hard mask layers.

10. The method of claim 1 wherein the first and third dielectric layers comprise Black Diamond™.

11. The method of claim 2 additionally comprising simultaneously filling the trench and the via hole with a conductive material, whereby a dual damascene structure is formed.

12. The method of claim 11 wherein the conductive material comprises one or more materials selected from the group consisting of metals, alloys, metallic superconductors and nonmetallic superconductors.

13. A method of forming a structure on a substrate, the method comprising:
a) forming a dielectric stack including an etch stop layer;
b) forming a sacrificial etch segment in the etch stop layer;
c) forming a first trench on the etch stop layer;
d) forming a second trench on the etch stop layer, such that the sacrificial etch segment is positioned between the first and second trenches;
e) forming a first via hole underlying the first trench, such that the first via hole communicates with the first trench;
f) forming a second via hole underlying the second trench, such that the second via hole communicates with the second trench, wherein: (1) the first trench and the first via hole, and (2) the second trench and the second via hole are adapted for forming a first dual damascene structure and a second dual damascene structure respectively.

14. The method of claim 13 additionally comprising:
a) forming the first trench at a predetermined distance D from the second trench; and.
b) forming the sacrificial etch segment at a predetermined width W, such that D exceeds W by a measure N.

15. The method of claim 14 wherein N is at least 0.02µ.

16. The method of claim 13 wherein the etch stop layer comprises one or more dielectric materials selected from the group consisting of silicon oxides, silicon nitrides and silicon carbides.

17. The method of claim 13 additionally comprising simultaneously filling the first and second trenches, and the first and second via holes with a conductive material, whereby first and second dual damascene structures are formed.

18. The method of claim 17 wherein the conductive material comprises one or more materials selected from the group consisting of metals, alloys, metallic superconductors and nonmetallic superconductors.

19. A method of forming a structure on a substrate, the method comprising:
a) depositing a first dielectric layer on the substrate;
b) depositing a second dielectric layer on the first dielectric layer, wherein the first and second dielectric layers comprise materials having dissimilar etching characteristics;
c) depositing a first mask layer on the second dielectric layer wherein the first mask includes: (1) a first via pattern having a predetermined width T, (2) a second via pattern and (3) a sacrificial etch pattern positioned between the first and second via patterns such that the sacrificial etch pattern has a predetermined width W;
d) anisotropically etching the first and second via patterns through the second dielectric layer and forming a sacrificial etch segment by simultaneously anisotropically etching the sacrificial etch pattern through the second dielectric layer;
e) removing the first mask layer;
f) depositing a third dielectric layer on the second dielectric layer, wherein the second and third dielectric layers comprise materials having dissimilar etching characteristics; and
g) depositing a second mask layer on the third dielectric layer, wherein the second mask layer includes: (1) a first trench pattern overlaying the first via pattern and the third dielectric layer, and having a predetermined width P and (2) a second trench pattern overlaying the second via pattern and the third dielectric layer, and having a predetermined distance D between the first and second trench patterns wherein D exceeds W by a measure N, in which: (1) the first via pattern and the first trench pattern are adapted for forming a first dual damascene structure and (2) the second via pattern and the second trench pattern are adapted for forming a second dual damascene structure.

20. The method of claim 19 further comprising:
a) anisotropically etching the first and second trench patterns through the third dielectric layer, thereby forming a first trench and a second trench, additionally forming a third and a fourth via pattern; and
b) anisotropically etching the third and fourth via patterns through the first dielectric layer, thereby forming a first via hole and a second via hole.

21. The method of claim 20 wherein a cap layer is interposed between the substrate and the first dielectric layer.

22. The method of claim 21 additionally comprising:
a) anisotropically etching the first and second trenches through the second dielectric layer, and
b) simultaneously anisotropically etching the first and second via holes through the cap layer.

23. The method of claim 19 wherein the first and third dielectric layers comprise materials having similar etching characteristics.

24. The method of claim 19 wherein N is at least 0.02µ.

25. The method of claim 19 wherein the first and third dielectric layers comprise one or more dielectric materials selected from the group consisting of amorphous fluorinated carbon, organic spin-on, materials, spin-on glass, aero-gel, poly(arylene) ethers, fluorinated poly(arylene) ethers and divinyl siloxane benzocyclobutane.

26. The method of claim 25 wherein the second dielectric layer comprises one or more dielectric materials selected from the group consisting of silicon oxides, silicon nitrides and silicon carbides.

27. The method of claim 19 wherein the first and third dielectric layers comprise Black Diamond™.

28. The method of claim 19 wherein depositing a first mask layer comprises depositing a mask layer selected from the group consisting of photoresist mask layers, hard mask layers and combinations of photoresist mask layers and hard mask layers.

29. The method of claim 20 additionally comprising simultaneously filling: (1) the first trench and the first via hole, and (2) the second trench and the second via hole with a conductive material, whereby first and second dual damascene structures are formed.

30. The method of claim 29 wherein the conductive material comprises one or more materials selected from the group consisting of metals, alloys, metallic superconductors and nonmetallic superconductors.

31. The method of claim 19 wherein T exceeds P by a predetermined measure M.

32. The method of claim 31 wherein M is at least 0.02µ.

33. A method of forming a structure on a substrate, the method comprising:
a) depositing a first dielectric layer on a substrate;
b) depositing a second dielectric layer on the first dielectric layer, wherein the first and second dielectric layers comprise materials having dissimilar etching characteristics;
c) depositing a third dielectric layer on the second dielectric layer, wherein the second and third dielectric layers comprise materials having dissimilar etching characteristics and wherein the first and third dielectric layers comprise materials having similar etching characteristics;
d) depositing a hard mask layer on the third dielectric layer, wherein the second dielectric layer and the hard mask layer comprise materials having similar etching characteristics;
e) depositing a first photoresist layer including a first via pattern having a predetermined width X on the hard mask layer;
f) anisotropically etching the first via pattern through the hard mask layer;
g) removing the first photoresist layer from the hard mask layer; and
h) depositing a second photoresist layer including a trench pattern, having a predetermined width Y such that X exceeds Y by a predetermined measure Z, overlaying the via pattern on the hard mask layer and forming a second via pattern, whereby the trench pattern and the second via pattern are adapted for forming a dual damascene structure.

34. The method of claim 33 further comprising:
a) anisotropically etching the second via pattern through the third dielectric layer;
b) anisotropically etching the trench pattern through the hard mask layer and simultaneously anisotropically etching the second via pattern through the second dielectric layer; and
c) anisotropically etching the trench pattern through the third dielectric layer thereby forming a trench and simultaneously etching the second via pattern through the first dielectric layer thereby forming a via hole.

35. The method of claim 33 wherein Z is at least 0.02µ,

36. The method of claim 33 wherein the first and third dielectric layers comprise one or more dielectric materials selected from the group consisting of amorphous fluorinated carbon, organic spin-on materials, spin-on glass, aero-gel, poly(arylene) ethers, fluorinated poly(arylene) ethers and divinyl siloxane benzocyclobutane.

37. The method of claim 36 wherein the second dielectric layer comprises one or more dielectric materials selected from the group consisting of silicon oxides, silicon nitrides and silicon carbides.

38. The method of claim 33 wherein the first and third dielectric layers comprise Black Diamond™.

39. The method of claim 34 additionally comprising simultaneously filling the trench and the via hole with a conductive material, whereby a dual damascene structure is formed.

40. The method of claim 39 wherein the conductive material comprises one or more materials selected from the group consisting of metals, alloys, metallic superconductors and nonmetallic superconductors.

41. A device comprising:
a) a dielectric stack comprising a plurality of dielectric layers including an etch stop layer:
b) a first region in the stack defining a first trench positioned on the etch stop layer;
c) a second region in the stack defining a second trench positioned on the etch stop layer;
d) a third region in the stack contacting the first trench and defining a first via hole underlying the first trench;
e) a fourth region in the stack contacting the second trench and defining a second via hole underlying the second trench; and
f) a sacrificial etch segment in the etch stop layer positioned between the first and second trenches, wherein: (1) the first trench and first via hole, and (2) the second trench and the second via hole are adapted for forming a first dual damascene structure and a second dual damascene structure.

42. An apparatus for controlling the formation of a fabricated structure on a substrate, the apparatus comprising:
a) at least one controller adapted for interacting with a plurality of fabrication stations including: (1) a first fabrication station for forming a dielectric stack including an etch stop layer, (2) a second fabrication station for forming a sacrificial etch segment in the etch stop layer, (3) a third fabrication station for forming a first trench on the etch stop layer, (4) a fourth fabrication station for forming a second trench on the etch stop layer, (5) a fifth fabrication station for forming a first via hole underlying the first trench and (6) a sixth fabrication station for forming a second via hole underlying the second trench, and
b) a data structure which causes the controller to control the formation of the fabricated structure.
